# EUROPEAN PATENT APPLICATION

(11) **EP 4 819 786 A1**
(43) Date of publication of application: **07.10.2026**
(21) Application number: 25216968.5
(22) Date of filing: 19.11.2025
(51) Int. Cl.: H10B 41/27, H10B 43/27

(54) **SEMICONDUCTOR DEVICE AND ELECTRONIC SYSTEM INCLUDING THE SAME**

(30) Priority: 31.03.2025 KR 20250041630
(71) Applicant: Samsung Electronics Co., Ltd., Suwon-si, Gyeonggi-do 16677 (KR)
(72) Inventor: LEE, Tae Gon, 16677 Suwon-si, Gyeonggi-do (KR); KWON, Youngwoo, 16677 Suwon-si, Gyeonggi-do (KR); KWON, Ojin, 16677 Suwon-si, Gyeonggi-do (KR); KIM, WooJae, 16677 Suwon-si, Gyeonggi-do (KR); PARK, Jung-Hwan, 16677 Suwon-si, Gyeonggi-do (KR); LEE, Minjeong, 16677 Suwon-si, Gyeonggi-do (KR); LIM, Sunyoung, 16677 Suwon-si, Gyeonggi-do (KR); CHA, Jaehoon, 16677 Suwon-si, Gyeonggi-do (KR); HONG, Seungwan, 16677 Suwon-si, Gyeonggi-do (KR)
(74) Representative: Kuhnen & Wacker Patent- und Rechtsanwaltsbüro PartG mbB

(57) **Abstract**

A semiconductor device according to an embodiment may include a gate stacking structure (120), a channel structure, and a gate contact (172). The gate stacking structure (120) may include a plurality of air gap layers (130g) and a plurality of gate electrodes (130) alternately stacked to on each other. The channel structure may pass through the gate stacking structure (120). The channel structure may include a channel layer (140) and a gate dielectric layer (150). The gate dielectric layer (150) may include a charge storage layer (154) including a plurality of storage portions (154p) spaced apart from each other. The plurality of storage portions (154p) may correspond to the plurality of gate electrodes, respectively. The gate contact (172) may pass through the gate stacking structure (120) that includes the plurality of air gap layers (130g) and the plurality of gate electrodes (130). The gate contact (172) may be electrically connected to a connection gate electrode (130c) of the plurality of gate electrodes (130).

## Description

### BACKGROUND

### (a) Field

The present disclosure relates to a semiconductor device and an electronic system including the same, and more particularly, to a semiconductor device having an improved structure and an electronic system including the same.

### (b) Description of the Related Art

In an electronic system implementing a data storage, a semiconductor device capable of storing high-capacity data is in demand. Accordingly, a method for increasing a data storage capacity of a semiconductor device is being researched. For example, as one method for increasing a data storage capacity of a semiconductor device, a semiconductor device including three-dimensionally arranged memory cells instead of two-dimensionally arranged memory cells has been proposed.

### SUMMARY

The present disclosure relates to a semiconductor device capable of improving performance and/or reliability and an electronic system including the same.

A semiconductor device according to an embodiment may include a stacking structure including a sacrificial stacking structure and a gate stacking structure; and a channel structure passing through the gate stacking structure. The channel structure may include a channel layer and a gate dielectric layer. The gate dielectric layer may include a charge storage layer including a plurality of storage portions spaced apart from each other. The sacrificial stacking structure may include a first interlayer sacrificial layer and a second interlayer sacrificial layer. The first interlayer sacrificial layer and the second interlayer sacrificial layer may include different materials and may be alternately stacked on each other. The gate stacking structure may include an air gap layer and a gate structure. In a thickness direction of the stacking structure, the air gap layer may correspond to at least a portion of the first interlayer sacrificial layer and the gate structure may correspond to at least the second interlayer sacrificial layer. The gate structure may include a gate electrode and a cover insulation layer. The cover insulation layer may be on the gate electrode and may be adjacent to the air gap layer. The cover insulation layer may include a first cover portion extending in a horizontal direction on the gate electrode. The gate electrode and at least a portion of the first cover portion of the cover insulation layer may correspond to or overlap the second interlayer sacrificial layer in the thickness direction of the stacking structure.

A semiconductor device according to an embodiment may include a gate stacking structure including a plurality of air gap layers and a plurality of gate electrodes alternately stacked on each other; a channel structure passing through the gate stacking structure, wherein the channel structure may include a channel layer and a gate dielectric layer, wherein the gate dielectric layer may include a charge storage layer including a plurality of storage portions spaced apart from each other, wherein the plurality of storage portions may correspond to the plurality of gate electrodes, respectively; and a gate contact passing through the gate stacking structure that includes the plurality of air gap layers and the plurality of gate electrodes, the gate contact being electrically connected to a connection gate electrode of the plurality of gate electrodes.

An electron system according to an embodiment may include a main substrate; a semiconductor device on the main substrate; and a controller electrically connected to the semiconductor device on the main substrate. The semiconductor device may include a stacking structure and a channel structure. The stacking structure may include a sacrificial stacking structure and a gate stacking structure. The channel structure may pass through the gate stacking structure. The channel structure may include a channel layer and a gate dielectric layer. The gate dielectric layer may include a charge storage layer including a plurality of storage portions spaced apart from each other. The sacrificial stacking structure may include a first interlayer sacrificial layer and a second interlayer sacrificial layer. The first interlayer sacrificial layer and the second interlayer sacrificial layer may include different materials and may be alternately stacked on each other. The gate stacking structure may include an air gap layer and a gate structure. In a thickness direction of the stacking structure, the air gap layer may correspond to at least a portion of the first interlayer sacrificial layer and the gate structure may correspond to at least the second interlayer sacrificial layer. The gate structure may include a gate electrode and a cover insulation layer. The cover insulation layer may be on the gate electrode and may be adjacent to the air gap layer. The cover insulation layer may include a first cover portion extending in a horizontal direction on the gate electrode. The gate electrode and at least a portion of the first cover portion of the cover insulation layer may be disposed to correspond to or overlap the second interlayer sacrificial layer in the thickness direction of the stacking structure.

According to an embodiment, a charge storage layer may have a separated storage structure including a plurality of storage portions spaced apart from each other, and a charge loss may be limited and/or minimized. Further, a gate stacking structure may include an air gap layer, and parasitic capacitance may be reduced and/or a breakdown voltage may be improved. A cover insulation layer may surround and protect a gate electrode and a blocking layer, and stability of the gate electrode and the blocking layer may be improved. Thereby, performance and reliability of a semiconductor device may be improved. For example, a stacking structure may include a sacrificial stacking structure and a gate stacking structure, and a form of the stacking structure may maximally maintain and performance and reliability of the semiconductor device may be improved.

According to an embodiment, a first interlayer sacrificial layer and a second interlayer sacrificial layer may be formed and the first interlayer sacrificial layer may be removed, and thereafter, a separation process may be performed using a space in which the first interlayer sacrificial layer is removed. Therefore, a plurality of storage portions may be easily formed. A third interlayer sacrificial layer may be formed in the space in which the first interlayer sacrificial layer is removed and the second interlayer sacrificial layer may be removed, and thereafter, a cover insulation layer, a gate electrode, and/or a blocking layer may be formed in a space in which the second interlayer sacrificial layer is removed. Therefore, the cover insulation layer may have a structure surrounding and protecting the gate electrode and/or the blocking layer. Thereby, the gate electrode and/or the blocking layer may not have a dangling structure in which the gate electrode and/or the blocking layer is hanging alone from the gate dielectric layer in a manufacturing process, and stability of the gate electrode and/or the blocking layer may be improved. By removing the third interlayer sacrificial layer, an air gap layer may be easily formed. Accordingly, a semiconductor device having improved performance and/or reliability may be more easily and/or stably formed.

### BRIEF DESCRIPTION OF THE DRAWINGS

FIG. 1 is a cross-sectional view schematically illustrating a semiconductor device according to an embodiment.
FIG. 2 is a cross-sectional view conceptually illustrating a gate contact and a dummy structure disposed in a connection region of the semiconductor device illustrated in FIG. 1.
FIG. 3 is a partial cross-sectional view illustrating a portion of the semiconductor device illustrated in FIG. 1.
FIG. 4 is an enlarged view illustrating a portion A and a portion B in FIG. 3.
FIG. 5 is an enlarged view of a portion C in FIG. 3.
FIG. 6 is an enlarged view of a portion D in FIG. 3.
FIG. 7 to FIG. 27 are cross-sectional views illustrating a manufacturing method of a semiconductor device according to an embodiment.
FIG. 28 is a partial cross-sectional view illustrating a semiconductor device according to an embodiment.
FIG. 29 is a partial cross-sectional view illustrating a semiconductor device according to an embodiment.
FIG. 30 schematically illustrates an electronic system including a semiconductor device according to an embodiment.
FIG. 31 is a perspective view schematically illustrating an electronic system including a semiconductor device according to an embodiment.
FIG. 32 is a cross-sectional view schematically illustrating a semiconductor package according to an embodiments.

### DETAILED DESCRIPTION

Embodiments of the present disclosure will be described more fully hereinafter with reference to the accompanying drawings for those skilled in the art to which the present disclosure pertains to easily practice the present disclosure. The present disclosure may be implemented in various different forms and is not limited to the embodiments provided herein.

A portion unrelated to the description may be omitted in order to clearly describe the present disclosure, and the same or similar components may be denoted by the same reference numeral throughout the present specification.

Further, since a size and/or a thickness of a portion, a region, a member, a unit, a layer, a film, a substrate, or the like illustrated in the accompanying drawings may be arbitrarily illustrated for better understanding and convenience of explanation, the present disclosure is not limited to the illustrated size and/or thickness. In the drawings, thicknesses of a portion, a region, a member, a unit, a layer, a film, a substrate, or the like may be enlarged or exaggerated for convenience of explanation and/or simple illustration.

It will be understood that when a component such as a portion, a region, a member, a unit, a layer, a film, a substrate, or the like is referred to as being "on" or "above" another component, it may be directly on or above another component or an intervening component may also be present. In contrast, when a component is referred to as being "directly on" or "directly above" another component, there is no intervening component present. Further, when a component is referred to as being "on" or "above" a reference component, a component may be disposed on, above, or below the reference component, and does not necessarily be "on" or "above" the reference component toward an opposite direction of gravity.

In addition, throughout the specification, unless explicitly described to the contrary, the word "comprise", "include", or "contain", and variations such as "comprises", "comprising", "includes", "including", "contains" or "containing" will be understood to imply the inclusion of other components rather than the exclusion of any other components.

Further, throughout the specification, a phrase "on a plane", "in a plane", "on a plan view", or "in a plan view" may indicate a case where a portion is viewed from above or a top portion, and a phrase "on a cross-section", "in a cross-section", "on a cross-sectional view", or "in a cross-sectional view" may indicate a vertical cross-sectional view from a side.

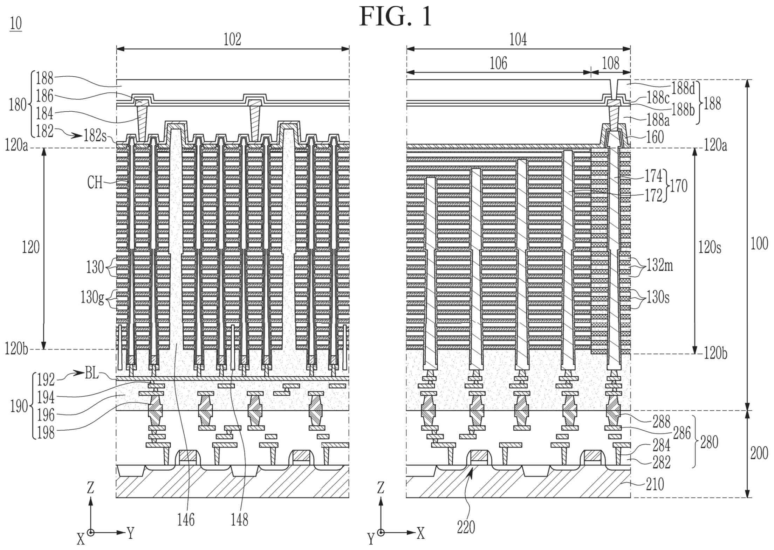

Hereinafter, referring to FIG. 1 to FIG. 6, a semiconductor device 10 according to an embodiment will be described in detail.

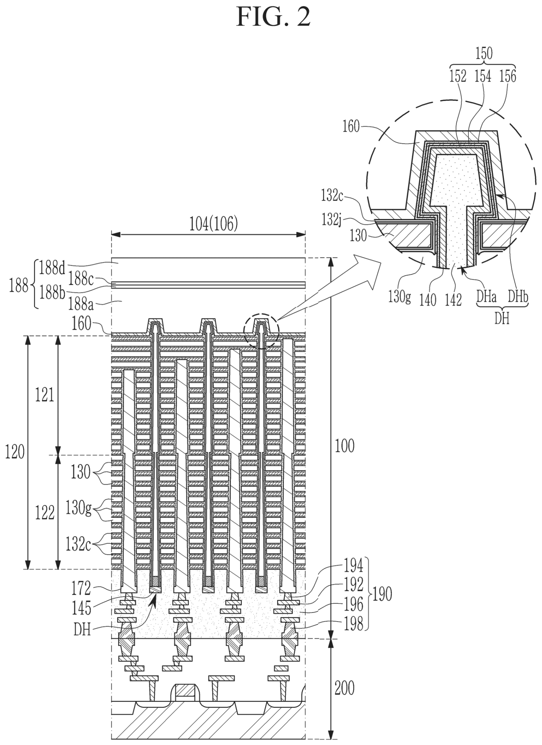

FIG. 1 is a cross-sectional view schematically illustrating a semiconductor device 10 according to an embodiment. FIG. 2 is a cross-sectional view conceptually illustrating a gate contact 172 and a dummy structure DH disposed in a connection region 104 of the semiconductor device 10 illustrated in FIG. 1. For simpler illustration and a clearer understanding, FIG. 1 mainly illustrates a gate contact 172 and an input/output connection wiring 174 disposed in the connection region 104. In FIG. 1, positions of the gate contact 172 and the input/output connection wiring 174 are conceptually illustrated.

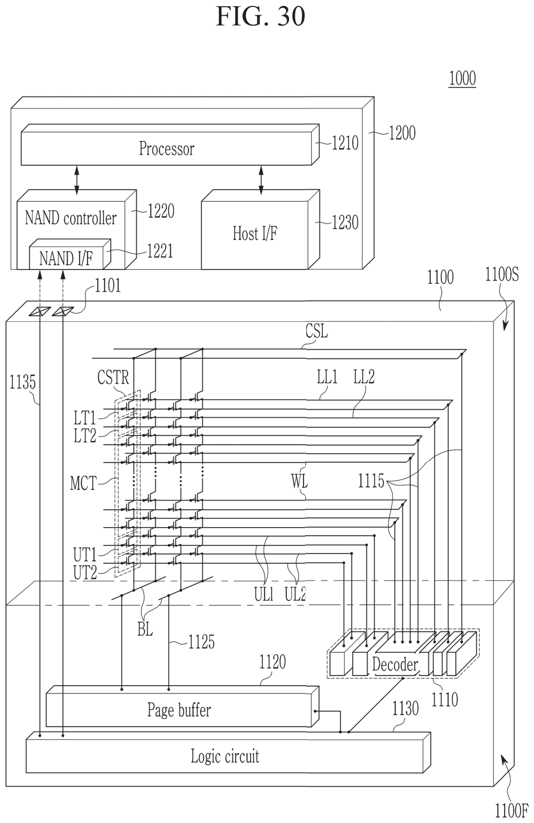

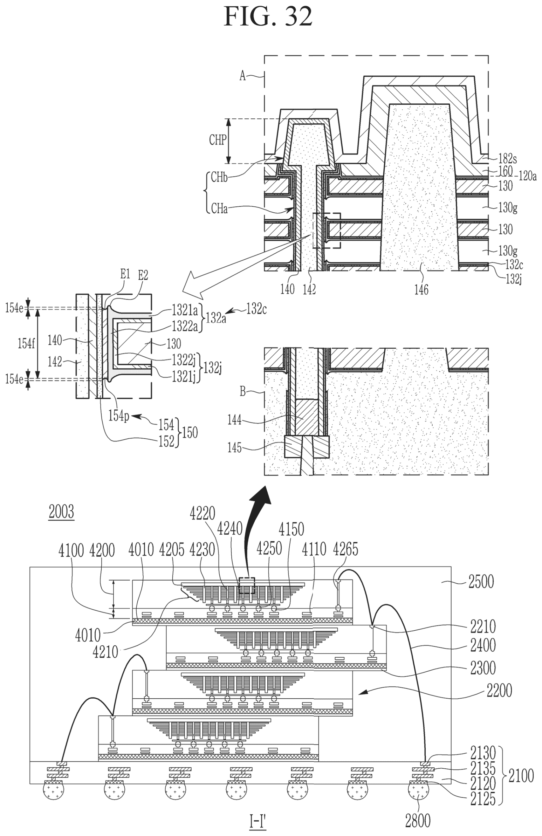

Referring to FIG. 1 and FIG. 2, a semiconductor device 10 according to an embodiment may include a cell region 100 that includes a memory cell structure and a circuit region 200 that includes a peripheral circuit structure configured to control an operation of the memory cell structure. For example, the circuit region 200 and the cell region 100 may correspond to a first structure 1100F and a second structure 1100S of a semiconductor device 1100 included in an electronic system 1000 illustrated in FIG. 30, respectively. For example, the circuit region 200 and the cell region 100 may be portions including a first structure 4100 and a second structure 4200 of a semiconductor chip 2200 illustrated in FIG. 32, respectively.

In an embodiment, the semiconductor device 10 may be a bonding semiconductor device formed by separately forming the cell region 100 and the circuit region 200 and thereafter bonding the cell region 100 to the circuit region 200. For example, the cell region 100 may be bonded to the circuit region 200 by a hybrid bonding process such as a chip to chip (C2C) bonding process, a chip-to-wafer bonding process, or a wafer-to-wafer bonding process. When the cell region 100 and the circuit region 200 are formed through separate processes, the cell region 100 may be limited and/or prevented from affecting the circuit region 200 in a manufacturing process of the cell region 100. For example, the semiconductor device 10 may be a bonding vertical NAND (BV NAND) flash memory.

In an embodiment, the cell region 100 may be disposed on the circuit region 200. Accordingly, an area corresponding to the circuit region 200 does not need to be separate from the cell region 100 in a lateral direction. Therefore, an area of the semiconductor device 10 may be reduced.

The circuit region 200 may include a peripheral circuit structure on a substrate 210, and the cell region 100 may include a gate stacking structure 120 and a channel structure CH as a memory cell structure. The circuit region 200 may include a circuit element 220 and a circuit wiring portion 280, and the cell region 100 may include a penetration contact 170 and cell wiring portions 180 and 190.

The circuit region 200 may include a substrate 210, and a circuit element 220 and a circuit wiring portion 280 on or at a surface (e.g., an upper surface in FIG. 1) of the substrate 210.

The substrate 210 may be a semiconductor substrate including a semiconductor material. For example, the substrate 210 may be a semiconductor substrate including or being formed of a semiconductor material or may be a semiconductor substrate in which a semiconductor layer is on a base substrate. For example, the substrate 210 may include or be formed of silicon, germanium, silicon-germanium, silicon on insulator (SOI), germanium on insulator (GOI), or the like.

The circuit element 220 may include any of various circuit elements that control an operation of the memory cell structure included in the cell region 100. For example, the circuit element 220 may constitute the peripheral circuit structure such as a decoder circuit 1110 (refer to FIG. 30), a page buffer 1120 (refer to FIG. 30), a logic circuit 1130 (refer to FIG. 30), or the like.

The circuit element 220 may include, for example, a transistor, but the embodiments are not limited thereto. For example, the circuit element 220 may include not only an active element such as the transistor or the like but also a passive element such as a capacitor, a resistor, an inductor, or the like.

The circuit wiring portion 280 may be electrically connected to the circuit element 220. In an embodiment, the circuit wiring portion 280 may include a plurality of wiring layers 286 that are spaced apart from each other while interposing an insulation layer 282 therebetween and are electrically connected by a contact via 284 to form a desired path, and a bonding structure 288 that is electrically connected to the plurality of wiring layers 286 and is disposed in a portion facing the cell region 100. The wiring layer 286 or the contact via 284 may include any of various conductive materials, and the insulation layer 282 may include any of various insulating materials.

The cell region 100 may include a cell array region 102 and a connection region 104. The cell array region 102 may be a region in which the channel structure CH is disposed, and the connection region 104 may be a region other than the cell array region 102.

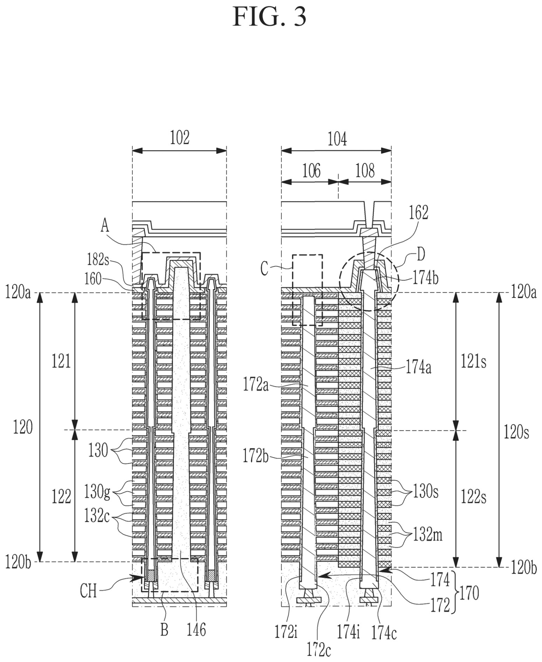

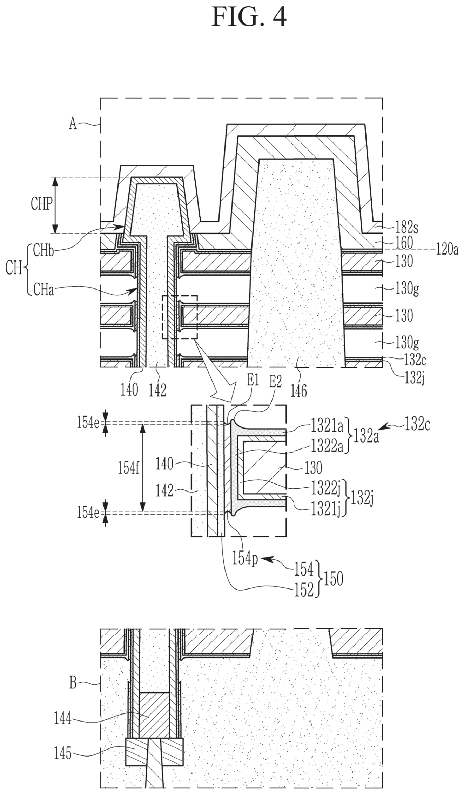

In the cell array region 102 and the connection region 104, a stacking structure including a gate stacking structure 120 and a sacrificial stacking structure 120s may be disposed. The gate stacking structure 120 may include an air gap layer 130g and a gate structure (a gate electrode 130, a cover insulation layer 132c (refer to FIG. 3), and/or a blocking layer 132j (refer to FIG. 4)), and the sacrificial stacking structure 120s may include a first interlayer sacrificial layer 130s and a second interlayer sacrificial layer 132m. The gate stacking structure 120 and the sacrificial stacking structure 120s will be described later in detail with reference to FIG. 3.

For example, in the cell array region 102, the gate stacking structure 120 may be disposed. The connection region 104 may include a first region 106 in which the gate stacking structure 120 is disposed and a second region 108 in which the sacrificial stacking structure 120s is disposed. In some embodiments, the connection region 104 may further include a region other than the first region 106 and the second region 108.

The gate stacking structure 120, the sacrificial stacking structure 120s, or the stacking structure may have a first surface 120a and a second surface 120b opposite to each other. The first surface 120a of the gate stacking structure 120, the sacrificial stacking structure 120s, or the stacking structure may be a surface (an upper surface in FIG. 1) adjacent to a first cell wiring portion 180, or may be a surface opposite to a channel pad 144, a second cell wiring portion 190, or a circuit region 200. The second surface 120b of the gate stacking structure 120, the sacrificial stacking structure 120s, or the stacking structure may be a surface (a lower surface in FIG. 1) opposite to the first cell wiring portion 180, or may be a surface adjacent to the channel pad 144, the second cell wiring portion 190, or the circuit region 200.

In the cell array region 102, the channel structure CH may extend to pass through the gate stacking structure 120 in a thickness direction of the semiconductor device 10 (a Z-axis direction in the drawings). The thickness direction of the semiconductor device 10 may be a thickness direction of the stacking structure, a thickness direction of the gate stacking structure 120, a thickness direction of the sacrificial stacking structure 120s, an extension direction of the channel structure CH, or a vertical direction. The channel structure CH will be described later in detail with reference to FIG. 4.

In an embodiment, the gate stacking structure 120 may be divided into a plurality of portions in a plan view by a separation structure 146 extending in the thickness direction of the semiconductor device 10 (the Z-axis direction in the drawings) to pass through the gate stacking structure 120. A separation pattern 148 may be disposed to be adjacent to the second surface 120b of the gate stacking structure 120. In a plan view, the separation structure 146 and/or the separation pattern 148 may extend in a first direction (an X-axis direction in the drawings). A plurality of separation structures 146 and/or a plurality of separation patterns148 may be spaced apart from each other at desired and/or alternatively predetermined intervals in a second direction (a Y-axis direction in the drawings). The first direction may be an extension direction of the gate electrode 130, and the second direction may be a crossing direction that crosses or intersects the gate electrode 130.

The separation structure 146 or the separation pattern 148 may include any of various insulating materials. For example, the separation structure 146 or the separation pattern 148 may include or be formed of an insulating material such as silicon oxide, silicon nitride, or silicon oxynitride. However, the embodiments are not limited thereto, and a structure, a shape, a material, or the like of the separation structure 146 or the separation pattern 148 may be variously modified.

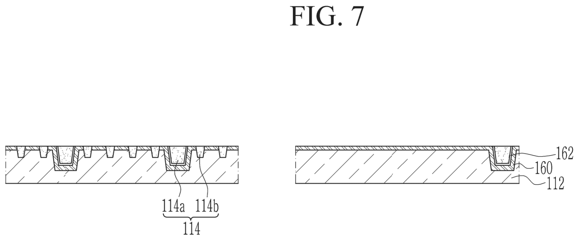

In an embodiment, the separation structure 146 may include a separation penetration portion and a separation protrusion portion. The separation penetration portion may pass through the gate stacking structure 120, and the separation protrusion portion may be disposed on the first surface 120a of the gate stacking structure 120. The separation protrusion portion may correspond to a portion in which a first etch stopping pattern 114a (refer to FIG. 7) was disposed.

To connect the gate stacking structure 120 and the channel structure CH in the cell array region 102 to the circuit region 200 (e.g., the circuit element 220) or an external circuit, the connection region 104, the penetration contact 170, and the cell wiring portions 180 and 190 may be included. The connection region 104 may be disposed at a periphery of the cell array region 102. The penetration contact 170 and portions of the cell wiring portions 180 and 190 may be disposed in the connection region 104.

The penetration contact 170 may include a plurality of gate contacts 172 electrically connected to a plurality of gate electrodes 130, respectively, and the input/output connection wiring 174.

In an embodiment, the gate stacking structure 120 may be disposed in the cell array region 102 and the first region 106. For example, in the first region 106, the gate stacking structure 120 may be entirely disposed in a portion except for the separation structure 146 and/or the separation pattern 148. For example, in the first region 106, extension lengths of the plurality of gate electrodes 130 may be substantially same. Substantially same may refer to have a difference within a process error (e.g., less than 10%). However, the embodiments are not limited thereto.

In the first region 106, each of the plurality of gate contacts 172 may pass through at least a portion of the gate stacking structure 120, and may be electrically connect to (e.g., in contact with ) a respective one of the plurality of gate electrodes 130. For example, a plurality of penetration parts (e.g., a plurality of penetration parts for gate contacts) may individually pass through the gate stacking structure 120, and may be spaced apart from each other while interposing the gate stacking structure 120 therebetween. One gate contact 172 may be disposed in one penetration part. For example, the plurality of penetration parts may be spaced apart from to one-to-one correspond to the plurality of gate contacts 172. In an embodiment, the penetration part may have any of various planar shapes, such as, a circular shape, a polygonal shape, an oval shape, or the like, and the embodiments are not limited to a planar shape of the penetration part.

Based on one gate contact 172, a plurality of gate electrodes 130 may include a connection gate electrode electrically connected to one gate contact 172, and may include a penetrated gate electrode and/or a remaining gate electrode. The penetrated gate electrode may be disposed between the connection gate electrode and the second surface 120b of the gate stacking structure 120, and may be passed through by the gate contact 172. The remaining gate electrode may be disposed between the connection gate electrode and the first surface 120a of the gate stacking structure 120, and may not be passed through by the gate contact 172. However, the embodiments are not limited thereto. In some embodiments, the remaining gate electrode may be passed through by the gate contact 172.

For example, each gate contact 172 may extend from the second surface 120b of the gate stacking structure 120 toward the first surface 120a, and may pass through a portion of the gate stacking structure 120 in the thickness direction of the semiconductor device 10 (the Z-axis direction in the drawings). In the thickness direction of the semiconductor device 10 (the Z-axis direction in the drawings), the plurality of gate electrodes 130 may be disposed at different heights or different levels, and the plurality of gate contacts 172 may have different lengths or different depths to reach the plurality of gate electrodes 130, respectively. For example, a first gate contact may be electrically connected to a first gate electrode, and a second gate contact may be electrically connected to a second gate electrode. An n-th gate contact may be electrically connected an n-th gate electrode. The n may be a natural number greater than 1.

For example, each gate contact 172 may be electrically connected to (e.g., be in contact with) an upper surface of the connection gate electrode. However, the embodiments are not limited thereto. Each gate contact 172 may be electrically connected to (e.g., in contact with) another portion (e.g., a side surface) of the connection gate electrode.

Accordingly, a pad region (e.g., a pad insulation layer) through which a plurality of gate contacts 172 pass together, or an additional insulation layer (e.g., a pad insulation layer) that is other than a first side insulation layer 172i (refer to FIG. 3) and is disposed between the plurality of gate contacts 172, and a portion (e.g., the pad region) in which the gate stacking structure 120 is removed to have a stair shape for an electrical connection between the gate electrode 130 and the gate contact 172 may not be provided. That is, the plurality of gate contacts 172 may be individually electrically connected to the plurality of gate electrodes 130, respectively, without the pad region or the pad insulation layer. Accordingly, a process of electrically connecting the gate contact 172 and the gate electrode 130 may be simplified, and an area of the connection region 104 may be reduced.

On the other hand, in a comparative example including a pad region, a process of etching a portion of a gate stacking structure (e.g., a process of forming a portion of a stair shape), a process of forming a pad insulation layer covering the stair shape of the gate stacking structure, and a process of electrically connecting a plurality of gate contacts that pass through one pad insulation layer to a plurality of gate electrodes, respectively, may be performed. Accordingly, the process of forming the pad region and the process of forming the gate contact may be complicated. In the pad region or the pad insulation layer through which the plurality of gate contacts pass, an interval between the plurality of gate contacts may be increased to limit and/or prevent a mis-alignment of the gate contact. Accordingly, an area of a connection region may be large.

For simple illustration and a clear understanding, in the drawings, it is illustrated as an example that the depths of the plurality of gate contacts 172 may sequentially increase away from the cell array region 102, but the embodiments are not limited thereto. An arrangement of the plurality of gate contacts 172 may be variously modified.

In the connection region 104, the input/output connection wiring 174 may pass through the stacking structure. In FIG. 1, it is illustrated as an example that the input/output connection wiring 174 is disposed in the second region 108 in which the sacrificial stacking structure 120s is disposed, and passes through the sacrificial stacking structure 120s. However, the embodiments are not limited thereto. In some embodiments, the input/output connection wiring 174 may be disposed in a region in which the gate stacking structure 120 is disposed, and may pass through the gate stacking structure 120. In some embodiments, the input/output connection wiring 174 may be disposed in a region in which a cell insulation layer is disposed without the gate stacking structure 120 and the sacrificial stacking structure 120s, and may pass through the cell insulation layer. Other various modified embodiments are possible.

The input/output connection wiring 174 may be electrically connected to the first cell wiring portion 180. For example, the input/output connection wiring 174 may be electrically connected to a pad 186 (e.g., an input/output pad). In FIG. 1, it is illustrated as an example that the input/output connection wiring 174 is electrically connected to the pad 186 (e.g., the input/output pad) through a first contact 184 (e.g., an input/output connection contact) of the first cell wiring portion 180 that passes through a wiring insulation layer 188 (e.g., a first wiring insulation layer 188a) of the first cell wiring portion 180. However, the embodiments are not limited thereto. The input/output connection wiring 174 and the first cell wiring portion 180 may be electrically connected by any of various structure. At least one of a plurality of input/output connection wirings 174 may be electrically connected to one or some of bonding structures 198 of the cell region 100. In some embodiments, an additional input/output pad included in the circuit region 200 and electrically connected to the circuit region 200 may be provided.

The cell wiring portion 180 and 190 may include a first cell wiring portion 180 on the first surface 120a of the stacking structure and a second cell wiring portion 190 on the second surface 120b of the stacking structure.

For example, the first cell wiring portion 180 may include a first wiring layer 182, a first contact 184, a pad 186, and a wiring insulation layer 188. The first wiring layer 182 may be disposed on the first surface 120a of the stacking structure. The first contact 184 may be electrically connected to the first wiring layer 182. The pad 186 may be electrically connected to the first contact 184.

The first wiring layer 182 may include a horizontal conductive layer 182s. The horizontal conductive layer 182s may be electrically connected to the channel structure CH on the first surface 120a of the gate stacking structure 120. The horizontal conductive layer 182s may be a common source line. The first contact 184 may include a common source contact and an input/output connection contact. The common source contact may be electrically connected to the horizontal conductive layer 182s, and the input/output connection contact may be electrically connected to the input/output connection wiring 174. For example, the common source contact may electrically connect the horizontal conductive layer 182s and the pad 186, and the input/output connection contact may electrically connect the input/output connection wiring 174 and the pad 186.

The horizontal conductive layer 182s may include a semiconductor layer including a semiconductor material and/or a metal-including layer including a metallic material. The semiconductor layer of the horizontal conductive layer 182s may include or be formed of silicon, germanium, silicon-germanium, or the like. For example, the semiconductor layer of the horizontal conductive layer 182s may include or be formed of a doped semiconductor layer (e.g., an n-type or p-type polycrystalline silicon layer). The metal-including layer of the horizontal conductive layer 182s may include or be formed of tungsten (W), titanium (Ti), tantalum (Ta), copper (Cu), aluminum (Al), cobalt (Co), or ruthenium (Ru). For example, the horizontal conductive layer 182s may include the semiconductor layer and the metal-including layer. Therefore, a connection property with the channel structure CH may be improved by the semiconductor layer, and electrical resistance may be reduced by the metal-including layer. However, the embodiments are not limited thereto.

In an embodiment, the horizontal conductive layer 182s may be disposed on a channel exposed portion CHP (refer to FIG. 4), and the channel exposed portion CHP and the horizontal conductive layer 182s may be stably electrically connected to each other, regardless of two replacement processes of forming the gate stacking structure 120.

In an embodiment, the wiring insulation layer 188 of the first cell wiring portion 180 may include a plurality of layers (e.g., first to fourth wiring insulation layers 188a, 188b, 188c, and 188d). For example, the first wiring insulation layer 188a may be disposed on the first wiring layer 182, the pad 186 may be disposed on the first wiring insulation layer 188a, and the second to fourth wiring insulation layers 188b, 188c, and 188d may be disposed on the pad 186.

The first wiring insulation layer 188a may be a kind of a planarization layer covering the first wiring layer 182. The second wiring insulation layer 188b and the third wiring insulation layer 188c may be insulation layers for hydrogen passivation, and the fourth wiring insulation layer 188d may be a capping layer protecting the semiconductor device 10. The first to fourth wiring insulation layers 188a, 188b, 188c, and 188d may include or be formed of any of various insulating material, for example, silicon oxide, silicon nitride, silicon oxynitride, silicon carbide, an organic material, or the like. For example, the second wiring insulation layer 188b may include an insulating material layer including hydrogen (e.g., a silicon oxide layer including hydrogen), and the third wiring insulation layer 188c may include a barrier layer (e.g., a silicon nitride layer). However, the embodiments are not limited thereto. At least one of the first to fourth wiring insulation layers 188a, 188b, 188c, and 188d may be omitted, or an additional insulation layer other than the first to fourth wiring insulation layers 188a, 188b, 188c, and 188d may be included.

In an embodiment, the second cell wiring portion 190 may include a second wiring layer 192, a second contact 194, a bonding structure 198, and a wiring insulation layer 196. The second wiring layer 192 may be disposed on the second surface 120b of the stacking structure. The second contact 194 may be electrically connected to the second wiring layer 192. The bonding structure 198 may be electrically connected to the second wiring layer 192 and may be disposed in a portion facing the circuit region 200.

The second wiring layer 192 may include a bit line BL extending in the second direction (the Y-axis direction in the drawings). The second wiring layer 192 may further include a connection wiring electrically connected to the bit line BL, the gate contact 172, the input/output connection wiring 174, or the like.

The second contact 194 may electrically connect the channel structure CH to the bit line BL, may electrically connect the gate contact 172 or the input/output connection wiring 174 to the second wiring layer 192, or may electrically connect a plurality connection wirings included in the second wiring layer 192.

The wiring insulation layer 196 of the second cell wiring portion 190 may include an interlayer insulation layer and a bonding insulation layer. The interlayer insulation layer may be disposed at a periphery of the second wiring layer 192 and/or the second contact 194. The bonding insulation layer may be disposed at a periphery of the bonding structure 198 in a portion facing the circuit region 200. In FIG. 1, it is illustrated as an example that at least a portion of the interlayer insulation layer of the wiring insulation layer 196 and the separation structure 146 are formed by a same process, and the interlayer insulation layer of the wiring insulation layer 196 is connected to the separation structure 146. However, the embodiments are not limited thereto.

The first wiring layer 182, the first contact 184, the pad 186, the second wiring layer 192, or the second contact 194 may include any of various conductive materials, and the wiring insulation layer 188 of the first cell wiring portion 180 or the wiring insulation layer 196 of the second cell wiring portion 190 may include any of various insulating materials. For example, the first wiring layer 182, the first contact 184, the pad 186, the second wiring layer 192, or the second contact 194 may include or be formed of a metallic material (e.g., tungsten (W), titanium (Ti), tantalum (Ta), copper (Cu), aluminum (Al), cobalt (Co), ruthenium (Ru), or the like), a semiconductor material (e.g., polycrystalline silicon), metal nitride (e.g., tungsten nitride (WN), titanium nitride (TiN), tantalum nitride (TaN), or the like), or a combination thereof. For example, the wiring insulation layer 188 of the first cell wiring portion 180 or the wiring insulation layer 196 of the second cell wiring portion 190 may include or be formed of at least one of silicon oxide, silicon nitride and silicon oxynitride.

In the connection region 104, a dummy structure DH may be further provided. The dummy structure DH may be configured to alleviate a stress applied to the gate stacking structure 120. For example, the dummy structure DH may be disposed in the first region 106. However, the embodiments are not limited thereto, and the dummy structure DH may be disposed in the cell array region 102 and/or the second region 108. The channel structure CH will be described with reference to FIG. 4 and thereafter the dummy structure DH will be described in detail.

The dummy structure DH may be disposed at a periphery of the gate contact 172 to constitute an arrangement of a polygonal shape (e.g., a rectangular shape or a hexagonal shape) or a zigzag shape. However, the embodiments are not limited thereto, and an arrangement of the dummy structure DH may be variously modified. At least some of dummy structures DH may be across an edge of the gate electrode 130, and may be adjacent to (e.g., in contact with) the separation structure 146. Other various modified embodiments are possible.

In an embodiment, a first protective layer 160 may be disposed on the first surface 120a of the stacking structure. For example, the first protective layer 160 may be disposed between the first surface 120a of the stacking structure and the first wiring layer 182 (e.g., the horizontal conductive layer 182s) and/or between the first surface 120a of the stacking structure and the wiring insulation layer 188 (e.g., the first wiring insulation layer 188a). The stacking structure will be described with reference to FIG. 3 and thereafter the first protective layer 160 will be described in detail.

In an embodiment, the cell region 100 and the circuit region 200 may be bonded to each other by hybrid bonding. For example, the cell region 100 and the circuit region 200 may be bonded to each other by hybrid bonding including metal bonding between the bonding structures 198 and 288 and including insulation-layer bonding between bonding insulation layers at peripheries of the bonding structures 198 and 288.

For example, the bonding structure 198 of the cell region 100 and/or the bonding structure 288 of the circuit region 200 may include or be formed of at least one of copper, aluminum, tungsten, nickel, gold, tin, manganese, cobalt, titanium, tantalum, ruthenium and beryllium, or may include or be formed of an alloy including the above material. For example, the bonding structure 198 of the cell region 100 and the bonding structure 288 of the circuit region 200 may include copper so that the cell region 100 and the circuit region 200 may be bonded (e.g., directly bonded) to each other by copper-to-copper bonding.

For example, the bonding insulation layer of the cell region 100 and the bonding insulation layer of the circuit region 200 may include a same insulating material. For example, the bonding insulation layer of the cell region 100 and/or the bonding insulation layer of the circuit region 200 may include a layer including or being formed of silicon carbonitride at least at a boding surface. However, the embodiments are not limited thereto.

Referring to FIG. 3, the gate stacking structure 120 and the sacrificial stacking structure 120s will be described in detail.

FIG. 3 is a partial cross-sectional view illustrating a portion of the semiconductor device 10 illustrated in FIG. 1.

Referring to FIG. 3, in an embodiment, in the cell array region 102, and the first region 106 of the connection region 104, the gate stacking structure 120 may be disposed. In the second region 108 of the connection region 104, the sacrificial stacking structure 120s may be disposed.

In an embodiment, the sacrificial stacking structure 120s may include a plurality of first interlayer sacrificial layers 130s and a plurality of second interlayer sacrificial layers 132m alternately stacked to each other. The plurality of first interlayer sacrificial layers 130s and the plurality of second interlayer sacrificial layers 132m may include different materials. In an embodiment, the gate stacking structure 120 may include a plurality of gate structures while interposing an air gap layer 130g therebetween. For example, each of the plurality of gate structures may include a gate electrode 130, a cover insulation layer 132c, and/or a blocking layer 132j (refer to FIG. 4). For example, the cover insulation layer 132c may be disposed on the gate electrode 130 to be adjacent to the air gap layer 130g, and the air gap layer 130g may be disposed between portions (e.g., first cover portions) of the cover insulation layer 132c on two adjacent gate electrodes 130.

In an embodiment, the air gap layer 130g may be disposed between the plurality of gate electrodes 130, and parasitic capacitance that may be induced between the plurality of gate electrodes 130 may be reduced.

The stacking structure including the gate stacking structure 120 and the sacrificial stacking structure 120s may be formed by a manufacturing process including two replacement processes using the separation structure 146. The cell array region 102 and the first region 106 may be a region adjacent to the separation structure 146 and in which the replacement processes using the separation structure 146 are performed, and the second region 108 may be a region spaced apart from the separation structure 146 and in which the replacement processes using the separation structure 146 are not performed.

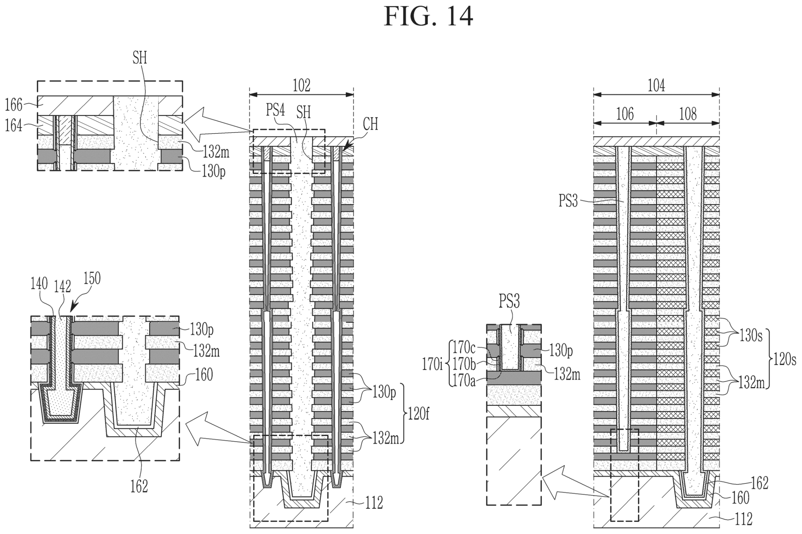

For example, in the cell array region 102, the first region 106, and the second region 108, by alternately stacking the plurality of second interlayer sacrificial layers 132m and the plurality of first interlayer sacrificial layers 130s, the sacrificial stacking structure 120s may be formed. In the cell array region 102 and the first region 106, a first replacement process may be performed. In the first replacement process, the plurality of first interlayer sacrificial layers 130s may be selectively removed and a plurality of third interlayer sacrificial layers 130p (refer to FIG. 14) may be formed. Subsequently, the cover insulation layer 132c may be formed on a surface of the third interlayer sacrificial layer 130p. Subsequently, in the cell array region 102 and the first region 106, a second replacement process may be performed. In the second replacement process, the plurality of second interlayer sacrificial layers 132m may be selectively removed, and the gate electrode 130 and/or the blocking layer 132j may be formed. Subsequently, the third interlayer sacrificial layer 130p may be removed to form the air gap layer 130g.

As described in the above, the first replacement process of replacing the first interlayer sacrificial layer 130s included in the sacrificial stacking structure 120s and the second replacement process of replacing the second interlayer sacrificial layer 132m included in the sacrificial stacking structure 120s may be performed to form the gate stacking structure 120. Accordingly, the gate stacking structure 120 and the sacrificial stacking structure 120s may not include a common insulation layer (e.g., an interlayer insulation layer including oxide or the second interlayer sacrificial layer 132m) formed by a same process.

In the thickness direction of the semiconductor device 10 (the Z-axis direction in the drawings), the air gap layer 130g in the gate stacking structure 120 may correspond to or overlap at least a portion of the first interlayer sacrificial layer 130s in the sacrificial stacking structure 120s, and the gate structure in the gate stacking structure 120 may correspond to the second interlayer sacrificial layer 132m. For example, the gate electrode 130, the cover insulation layer 132c (e.g., at least a portion of the first cover portion), and the blocking layer 132j (e.g., a first blocking portion 1321j) may correspond to or overlap each of the plurality of second interlayer sacrificial layers 132m in the sacrificial stacking structure 120s. For example, in the thickness direction of the semiconductor device 10, the air gap layer 130g in the gate stacking structure 120 may be disposed at a different position from the second interlayer sacrificial layer 132m in the sacrificial stacking structure 120s, and the gate electrode 130 in the gate stacking structure 120 may be disposed at a different position from the first interlayer sacrificial layer 130s in the sacrificial stacking structure 120s.

On the other hand, in a comparative example in which a gate stacking structure may be formed from a sacrificial stacking structure using one replacement process, the gate stacking structure and the sacrificial stacking structure may include an interlayer insulation layer including oxide and formed by a same process. In a thickness direction of a semiconductor device, a gate electrode in the gate stacking structure may correspond to a sacrificial insulation layer (e.g., an interlayer insulation layer including nitride) in the sacrificial stacking structure.

The first interlayer sacrificial layer 130s and the second interlayer sacrificial layer 132m may include different materials. For example, the first interlayer sacrificial layer 130s may include or be formed of silicon, silicon oxide, silicon carbide, silicon nitride, silicon oxynitride (SiONx), or the like, and may include or be formed of a material different from a material of the second interlayer sacrificial layer 132m. The second interlayer sacrificial layer 132m may include or be formed of silicon oxide, silicon nitride, silicon oxynitride, a low dielectric constant material, or the like, and may include or be formed of a material different from a material of the first interlayer sacrificial layer 130s. For example, the first interlayer sacrificial layer 130s or the second interlayer sacrificial layer 132m may include or be formed of a material different from a material of the gate electrode 130 and the air gap layer 130g included in the gate stacking structure 120.

For example, the first interlayer sacrificial layer 130s may include or be formed of nitride (e.g., silicon nitride), and the second interlayer sacrificial layer 132m may include or be formed of oxide (e.g., silicon oxide). However, the embodiments are not limited thereto.

The gate electrode 130 may include any of various conductive materials. For example, the gate electrode 130 may include or be formed of a metallic material (e.g., tungsten (W), titanium (Ti), tantalum (Ta), copper (Cu), aluminum (Al), cobalt (Co), ruthenium (Ru), or the like), a semiconductor material (e.g., polycrystalline silicon), metal nitride (e.g., tungsten nitride (WN), titanium nitride (TiN), tantalum nitride (TaN), or the like), or a combination thereof. As illustrated in an enlarged view in FIG. 2, the cover insulation layer 132c and/or the blocking layer 132j that is formed of an insulating material may be disposed outside the gate electrode 130. The air gap layer 130g may be formed of an empty space.

In an embodiment, the sacrificial stacking structure 120s may include a plurality of sacrificial stacking portions 121s and 122s sequentially stacked, and the gate stacking structure 120 may include a plurality of gate stacking portions 121 and 122 sequentially stacked. In the thickness direction of the semiconductor device 10 (the Z-axis direction in the drawings), the plurality of sacrificial stacking portions 121s and 122s may correspond to the plurality of gate stacking portions 121 and 122, respectively.

When the gate stacking structure 120 includes the plurality of gate stacking portions 121 and 122, a number of stacked gate electrodes 130 may be increased, and a number of memory cells may be increased with a stable structure. In FIG. 3, it is illustrated as an example that the sacrificial stacking structure 120s includes two sacrificial stacking portions 121s and 122s, and the gate stacking structure 120 includes two gate stacking portions 121 and 122, but the embodiments are not limited thereto. In some embodiments, the sacrificial stacking structure 120s may include one sacrificial stacking portion or three or more sacrificial stacking portions, and the gate stacking structure 120 may include one gate stacking portion or three or more gate stacking portions.

The first protective layer 160 on the first surface 120a of the stacking structure may protect a semiconductor substrate 112 (refer to FIG. 7) in the two replacement processes of forming the gate stacking structure 120. For example, the first protective layer 160 may protect the semiconductor substrate 112 in a process of removing the third interlayer sacrificial layer 130p. When the separation structure 146 is not entirely filled with a filling material and has a void, the first protective layer 160 may limit and/or prevent breakage or the like of the semiconductor substrate 112, which may occur due to void propagation toward the semiconductor substrate 112. The first protective layer 160 may cover the dummy structure DH (refer to FIG. 2), the separation structure 146, and/or the input/output connection wiring 174 on the first surface 120a of the stacking structure, and may limit and/or prevent an end of the dummy structure DH, the separation structure 146, and/or the input/output connection wiring 174 from being exposed to an outside. Thereby, stability may be improved.

The first protective layer 160 may include any of various insulating materials, and may include a material different from a material of the second interlayer sacrificial layer 132m or the separation structure 146. In an embodiment, the first protective layer 160 may have modulus, hardness, or a density higher than modulus, hardness, or a density of the second interlayer sacrificial layer 132m or the separation structure 146. Thereby, the first protective layer 160 may stably protect the semiconductor substrate 112. For example, the first protective layer 160 may include or be formed of a material same as a material of the first interlayer sacrificial layer 130s, but the embodiments are not limited thereto. In some embodiments, the first protective layer 160 may include a material different from a material of the first interlayer sacrificial layer 130s.

For example, the first protective layer 160 may include or be formed of silicon, silicon oxide, silicon carbide, silicon nitride, silicon oxynitride, or the like, and may include a material different from a material of the second interlayer sacrificial layer 132m or the separation structure 146. For example, the first protective layer 160 may include or be formed of silicon nitride or silicon oxynitride. However, the embodiments are not limited thereto.

Referring to FIG. 4 together with FIG. 1 to FIG. 3, the channel structure CH and the dummy structure DH will be described in more detail. FIG. 4 is an enlarged view illustrating a portion A and a portion B in FIG. 3.

Referring to FIG. 1 to FIG. 4, in an embodiment, the channel structure CH may include a channel penetration portion CHa and a channel expanded portion CHb. For example, the channel structure CH may include a channel layer 140, a gate dielectric layer 150, and a channel pad 144, and may further include a core insulation layer 142 and a second protective layer 145.

The channel penetration portion CHa may include a portion extending to pass through the gate stacking structure 120. The channel expanded portion CHb may be disposed on the first surface 120a of the gate stacking structure 120 and may have a width or an area greater than a width or an area of the channel penetration portion CHa. The width or the area of the channel penetration portion CHa or the channel expanded portion CHb may refer to a width (e.g., a long width or a diameter) or an area of a portion adjacent to the first surface 120a of the gate stacking structure 120. The channel expanded portion CHb may correspond to a portion in which a second etch stopping pattern 114b (refer to FIG. 7) was disposed.

The channel expanded portion CHb may include a channel exposed portion CHP on the first surface 120a of the gate stacking structure 120. In the channel exposed portion CHP, the channel layer 140 and/or the core insulation layer 142 may be included without the gate dielectric layer 150. The channel exposed portion CHP may not include the gate dielectric layer 150, and the channel layer 140 in the channel exposed portion CHP may be exposed to an outside of the gate stacking structure 120. the horizontal conductive layer 182s may be electrically connected to (e.g., in contact with) the channel layer 140 in the channel exposed portion CHP. However, the embodiments are not limited thereto, and a connection structure between the channel structure CH the horizontal conductive layer 182s may be variously modified.

In the channel penetration portion CHa and another portion of the channel expanded portion CHb, the gate dielectric layer 150, the channel layer 140, and the core insulation layer 142 may be included.

The channel layer 140 may include a portion extending in the thickness direction of the semiconductor device 10 (the Z-axis direction in the drawings) or the vertical direction. For example, in the channel penetration portion CHa, the channel layer 140 may include a portion longitudinally extending in the vertical direction to correspond to the plurality of gate electrodes 130. The channel layer 140 may include or be formed of a semiconductor material, for example, polycrystalline silicon, but the embodiments are not limited to a material of the channel layer 140.

The gate dielectric layer 150 may be disposed on the channel layer 140 between the gate electrode 130 and the channel layer 140. The gate dielectric layer 150 may include a first layer 152 and a second layer 154 sequentially disposed on the channel layer 140. The first layer 152 may be a tunneling layer that is capable of tunneling a charge, and the second layer 154 may be a charge storage layer used as a data storage region.

In an embodiment, the second layer 154, which is the charge storage layer, may include a plurality of storage portions 154p spaced apart from each other to correspond to the plurality of gate electrodes 130, respectively. For example, the second layer 154 may have a separated storage structure. For example, the second layer 154 extending in the vertical direction may have the separated storage structure in which the plurality of storage portions 154p are separated to be spaced apart from each other in the vertical direction. The plurality of storage portions 154p may be spaced apart from each other while interposing an interval portion disposed to correspond to at least a portion of the air gap layer 130g or the first interlayer sacrificial layer 132m. For example, the interval portion between the plurality of storage portions 154p may be formed by removing the first interlayer sacrificial layer 130s and removing a portion of the second layer 154 exposed between the plurality of storage portions 154p.

The gate dielectric layer 150 may include a portion extending in the thickness direction of the semiconductor device 10 (the Z-axis direction in the drawings) or the vertical direction. For example, in the channel penetration portion CHa, the first layer 152 may include a portion longitudinally extending in the vertical direction to correspond to the plurality of gate electrodes 130. For example, in the channel penetration portion CHa, the plurality of storage portions 154p of the second layer 154 may include a portion corresponding to a respective one of the plurality of gate electrodes 130 and extending in the vertical direction.

In an embodiment, the second layer 154, which is the charge storage layer, may have the separated storage structure, and may limit and/or prevent undesirable movement of charges in an extension direction of the second layer 154 to minimize a charge loss.

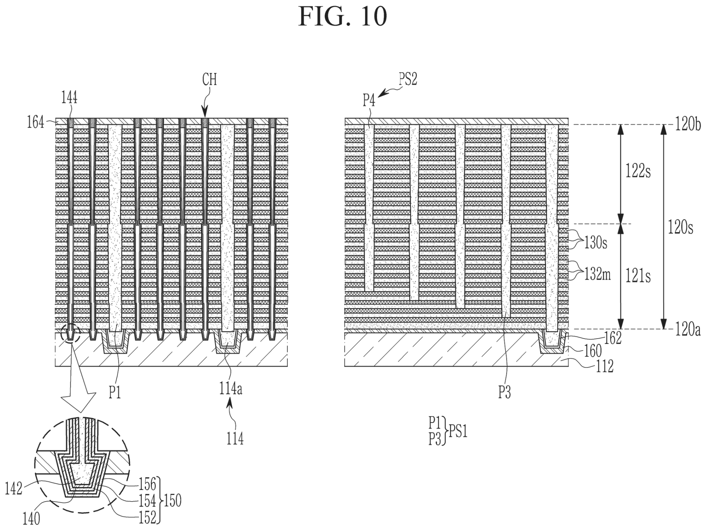

In an embodiment, the cover insulation layer 132c and/or the blocking layer 132j may be disposed between the second layer 154 and the gate electrode 130. The cover insulation layer 132c and the blocking layer 132j disposed between the second layer 154 and the gate electrode 130 may act as a portion (e.g., a blocking region) of the gate dielectric layer 150. The blocking region may limit and/or prevent undesirable movement of charges into the gate electrode 130. In FIG. 4, it is illustrated as an example that the gate dielectric layer 150 includes the first layer 152 and the second layer 154 and does not include a third layer 156 (refer to FIG. 10). In some embodiments, at least a portion of the third layer 156 that includes a portion extending in the vertical direction may remain between the second layer 154 and the cover insulation layer 132c, and may act as the blocking region.

In an embodiment, the first layer 152 and the third layer 156 may include or be formed of a same material, and the second layer 154 may include a material different from a material of the first layer 152 and the third layer 156, but the embodiments are not limited thereto. In some embodiments, the first layer 152 and the third layer 156 may include different materials.

For example, the first layer 152 and/or the third layer 156 may include a material different from a material of the first interlayer sacrificial layer 130s, and may include or be formed of a material same as a material of the second interlayer sacrificial layer 132m. For example, the second layer 154 may include or be formed of a material same as a material of the first interlayer sacrificial layer 130s, and may include a material different from a material of the second interlayer sacrificial layer 132m. Thereby, in a manufacturing process using the two replacement processes to form the gate stacking structure 120, the second layer 154 having the separated storage structure may be formed using an easy process.

For example, the first layer 152 may include or be formed of oxide (e.g., silicon oxide). The second layer 154 may include or be formed of polycrystalline silicon, nitride (e.g., silicon nitride), or the like. The third layer 156 may include or be formed of oxide (e.g., silicon oxide) or the like. However, the embodiments are not limited thereto, and the first layer 152, the second layer 154, and the third layer 156 may include any of various insulating materials.

The core insulation layer 142 may be disposed in the channel layer 140, but the core insulation layer 142 may be omitted. The core insulation layer 142 may include any of various insulating materials. For example, the core insulation layer 142 may include or be formed of silicon oxide, silicon nitride, silicon oxynitride, or a combination thereof.

The channel pad 144 may be disposed on at least one of the channel layer 140 and the gate dielectric layer 150 and may be electrically connected to the channel layer 140. For example, the channel pad 144 may cover an upper surface of the core insulation layer 142 and may be electrically connected to the channel layer 140. The channel pad 144 may include or be formed of a conductive material, for example, polycrystalline silicon doped with a dopant, but the embodiments are not limited thereto.

The second protective layer 145 may be disposed on the channel pad 144, the channel layer 140, the gate dielectric layer 150, and/or the channel pad 144. The second protective layer 145 may protect the channel structure CH (e.g., the channel pad 144 and/or the gate dielectric layer 150) in a process of forming the gate stacking structure 120 (e.g., a process of removing the second interlayer sacrificial layer 132m or a process of removing the third interlayer sacrificial layer 130p). The second protective layer 145 may act as a protective layer or a mask layer protecting the channel structure CH (e.g., the channel pad 144 and/or the gate dielectric layer 150) in a process of forming the separation pattern 148.

The second protective layer 145 may have an area same as or greater than an area of an end of the channel pad 144 or the channel structure CH adjacent to the second cell wiring portion 190. For example, the second protective layer 145 may have an area greater than the area of the end of the channel pad 144 or the channel structure CH adjacent to the second cell wiring portion 190. Thereby, the channel structure CH may be stably protected. However, the embodiments are not limited thereto. For example, a second contact 194 (e.g., a bit line contact) electrically connecting the channel structure CH and the bit line BL may pass through the second protective layer 145 to be connected to the channel pad 144.

The second protective layer 145 may include any of various insulating materials. For example, the second protective layer 145 may include a material different from a material of the second interlayer sacrificial layer 132m, the third interlayer sacrificial layer 130p, or the separation structure 146. Thereby, in the process of removing the second interlayer sacrificial layer 132m or the process of removing the third interlayer sacrificial layer 130p, the second protective layer 145 may stably protect the channel structure CH. For example, the second protective layer 145 may include a material different from a material of the wiring insulation layer 196 of the second cell wiring portion 190. Thereby, the second protective layer 145 may stably protect the channel structure CH in the process of forming the separation pattern 148. For example, the second protective layer 145 may include or be formed of a material same as a material of the first interlayer sacrificial layer 130s.

The second protective layer 145 may include or be formed of a material same as a material of the first protective layer 160, but the embodiments are not limited thereto. In some embodiments, the second protective layer 145 may include a material different from a material of the first protective layer 160.

For example, the second protective layer 145 may include or be formed of silicon, silicon oxide, silicon carbide, silicon nitride, silicon oxynitride, or the like, and may include a material different from a material of the second interlayer sacrificial layer 132m, the third interlayer sacrificial layer 130p, or the separation structure 146. For example, the second protective layer 145 may include or be formed of silicon nitride or silicon oxynitride. However, the embodiments are not limited thereto.

Each channel structure CH may form one memory cell string, and a plurality of channel structures CH may be spaced apart from each other while forming rows and columns in a plan view. For example, a plurality of channel structures CH may be disposed to form any of various shapes such as a lattice shape, a zigzag shape, or the like in a plan view. The channel structure CH may have a pillar shape. For example, in a cross-sectional view, the channel structure CH may have an inclined side surface such that a width of the channel structure CH decreases toward the first cell wiring portion 180 due to a high aspect ratio. However, the embodiments are not limited thereto, and an arrangement, a structure, a shape, or the like of the channel structure CH may be variously modified.

When the gate stacking structure 120 includes the plurality of gate stacking portions 121 and 122 as in the above, the channel structure CH may include a plurality of channel portions that respectively pass through the plurality of gate stacking portions 121 and 122. The plurality of channel portions may be connected to each other. In a cross-sectional view, each of the plurality of channel portions may have an inclined side surface such that a width of each of the plurality of channel portions decreases toward the first cell wiring portion 180 due to a high aspect ratio. A bent portion due to a difference in widths of the plurality of channel portions may be provided at a boundary portion between the plurality of gate stacking portions 121 and 122. In some embodiments, the plurality of channel portions may have an inclined side surface that continuously extends without the bent portion. In the drawings, it is illustrated as an example that each of the gate dielectric layer 150, the channel layer 140, and the core insulation layer 142 of the plurality of channel portions continuously extends to have an integral structure. In some embodiments, gate dielectric layers 150, channel layers 140, and core insulation layers 142 of a plurality of channel portions may be separately formed and be electrically connected to each other. In some embodiments, a separate channel pad may be additionally disposed at a boundary portion of the plurality of channel portions. As such, the embodiments are not limited to a shape or a type of the plurality of channel portions.

In an embodiment, the dummy structure DH may include a dummy penetration portion DHa and a dummy expanded portion DHb. For example, the dummy structure DH, which is a penetration structure, may include a penetration portion (e.g., the dummy penetration portion DHa) and an expanded portion (e.g., the dummy expanded portion DHb). The dummy penetration portion DHa may include a portion extending to pass through the gate stacking structure 120, and the dummy expanded portion DHb may be disposed on the first surface 120a of the gate stacking structure 120. The dummy expanded portion DHb may have a width or an area greater than a width or an area of the dummy penetration portion DHa. The width or the area of the dummy penetration portion DHa or the dummy expanded portion DHb may refer to a width (e.g., a long width or a diameter) or an area of a portion adjacent to the first surface 120a of the gate stacking structure 120. The dummy expanded portion DHb may correspond to a portion in which a first etch stopping pattern 114a (refer to FIG. 7) was disposed.

In FIG. 1 and FIG. 2, it is illustrated as an example that the dummy structure DH and the channel structure CH are formed by a same process and have a same or similar structure, shape, or material. For example, the dummy structure DH may include the channel layer 140, the gate dielectric layer 150, and the channel pad 144, and may further include the core insulation layer 142 and the second protective layer 145. In the dummy penetration portion DHa and the dummy expanded portion DHb of the dummy structure DH, the gate dielectric layer 150, the channel layer 140, and the core insulation layer 142 may be included, and the portion in which the channel layer 140 is exposed to the outside may not be included. In the dummy expanded portion DHb, the gate dielectric layer 150 may include the first layer 152, the second layer 154, and the third layer 156. The dummy structure DH may not be electrically connected to the bit line BL. For example, the dummy structure DH may have a size same as a size of the channel structure CH. Thereby, a manufacturing process of the dummy structure DH may be simplified. However, the embodiments are not limited thereto. In some embodiments, the dummy structure DH may be formed by a separate process from the channel structure CH, and/or the dummy structure DH may have a structure, a shape, a material, a size, or the like different from a structure, a shape, a material, a size, or the like of the channel structure CH.

In the drawings, it is illustrated as an example that the channel expanded portion CHb of the channel structure CH passes through the first protective layer 160, and the first protective layer 160 is disposed on the dummy expanded portion DHb of the dummy structure DH. Thereby, a process of removing a portion of the gate dielectric layer 150 in the channel exposed portion CHP of the channel expanded portion CHb to expose the channel layer 140 to the outside may be easily performed. However, the embodiments are not limited thereto. In some embodiments, the dummy expanded portion DHb of the dummy structure DH may pass through the first protective layer 160. Other various modified embodiments are possible.

Hereinafter, the second layer 154 (e.g., the storage portion 154p of the second layer 154), which is the charge storage layer, and the gate structure and the air gap layer 130g included in the gate stacking structure 120 will be described in more detail.

In an embodiment, the storage portion 154p of the second layer 154 may include outer portions 154e and a flat portion 154f. The outer portions 154e may be disposed at opposite sides in the thickness direction of the semiconductor device 10 (the Z-axis direction in the drawings). The outer portion 154e may be a region in which a thickness varies. The flat portion 154f may be disposed between the outer portions 154e or inside the outer portions 154e.

The flat portion 154f may have a substantially same thickness, and a surface of the flat portion 154f adjacent to the first layer 152 and a surface of the flat portion 154f adjacent to the cover insulation layer 132c may be flat. For example, the storage portion 154p of the second layer 154 may include the flat portion 154f, and may not include a portion of a rounded shape or a bent shape. Substantially same may refer to have a difference within a process error (e.g., less than 10%). However, the embodiments are not limited thereto.

In an embodiment, each of opposite side surfaces of the outer portion 154e may include a first concave portion E1 recessed or depressed toward an inner side in the thickness direction of the semiconductor device 10 (the Z-axis direction in the drawings). For example, by the first concave portion E1, a side surface of the outer portion 154e may be recesses or depressed in a central portion than in a portion adjacent to the tunneling layer or the first layer 152 and a portion adjacent to the cover insulation layer 132c or the gate electrode 130. This may be because a separation process of forming the separated storage structure may be performed through an etching process from the separation structure 146. In the etching process, the cover insulation layer 132c may act as a mask. On the other than, in a comparative example in which a separation process of forming a separated storage structure is formed from a penetration part for a channel structure in which a channel structure is disposed, a storage portion may have a shape in which a length gradually increase from a portion adjacent to a tunneling layer or a first layer to a portion adjacent to a gate electrode or may have a rounded shape.

In an embodiment, the gate structure may include the gate electrode 130, the cover insulation layer 132c, and the blocking layer 132j, and may be disposed at a position in which the storage portion 154p is disposed in the thickness direction of the semiconductor device 10 (the Z-axis direction in the drawings). The air gap layer 130g may be disposed in a region including the interval portion between the storage portions 154p in the thickness direction of the semiconductor device 10.

In an embodiment, the cover insulation layer 132c may include a portion adjacent to the air gap layer 130g and disposed at an edge portion of the air gap layer 130g. The cover insulation layer 132c may include a first cover portion (e.g., a horizontal portion) and a second cover portion (e.g., a first vertical portion). First cover portions may extend in a horizontal direction on a first surface (an upper surface in FIG. 4) and a second surface (a lower surface in FIG. 4) of each of the plurality of gate electrodes 130. The second cover portion may be disposed between the gate electrode 130 and the second layer 154 (e.g., the storage portion 154p) and may extend in the vertical direction.

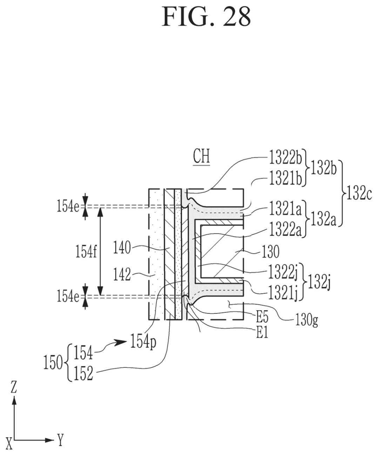

For example, the cover insulation layer 132c may include a first cover insulation layer 132a, and the first cover insulation layer 132a may include a first insulation portion 1321a constituting the first cover portion and a second insulation portion 1322a constituting the second cover portion. The first cover portion or the first insulation portion 1321a may be adjacent to the air gap layer 130g. For example, the cover insulation layer 132c may include a plurality of portions corresponding to the plurality of gate electrodes 130, respectively. For example, the cover insulation layer 132c may have a separated cover structure. Thereby, in the thickness direction of the semiconductor device 10 (the Z-axis direction in the drawings), a portion of the first layer 152 between the plurality of portions of the cover insulation layer 132c may be exposed to the air gap layer 130g. However, the embodiments are not limited thereto. An embodiment will be described in detail with reference to FIG. 28.

In the thickness direction of the semiconductor device 10, at least a portion of the first cover portion of the cover insulation layer 132c may correspond to or overlap a portion of the second interlayer sacrificial layer 132m. For example, in the thickness direction of the semiconductor device 10 (the Z-axis direction in the drawings), at least the gate electrode 130 and a portion (e.g., the first cover portion or the first insulation portion 1321a) of the cover insulation layer 132c may correspond to or overlap the second interlayer sacrificial layer 132m. Accordingly, in the thickness direction of the semiconductor device 10, a thickness of the gate electrode 130 may be less than a thickness of the second interlayer sacrificial layer 132m.

For example, the gate electrode 130 and the first insulation portions 1321a (e.g. the first cover portions of the first cover insulation layer 132a), which are disposed on the first surface and the second surface of the gate electrode 130 opposite to each other and extend in the horizontal direction, may correspond to or overlap the second interlayer sacrificial layer 132m. For example, a first surface (an upper surface in FIG. 4) of the first insulation portion 1321a (e.g., a first surface (an upper surface in FIG. 4) of the first cover portion on the first surface of the gate electrode 130) may be disposed on a same plane as a first surface (an upper surface in FIG. 4) of the second interlayer sacrificial layer 132m. For example, a second surface (a lower surface in FIG. 4) of the first insulation portion 1321a (e.g., a second surface (a lower surface in FIG. 4) of the first cover portion on the second surface of the gate electrode 130) may be disposed on a same plane as a second surface (a lower surface in FIG. 4) of the second interlayer sacrificial layer 132m. This may be because the cover insulation layer 132c (e.g., the first cover insulation layer 132a) and the gate electrode 130 may be formed in a portion in which the second interlayer sacrificial layer 132m is removed. For example, in an embodiment, the cover insulation layer 132c and the gate electrode 130 may be formed in the space in which the second interlayer sacrificial layer 132m including oxide is removed.

In an embodiment, each of opposite side surfaces of a portion of the cover insulation layer 132c adjacent to the second layer 154 (e.g., the second cover portion or the second insulation portion 1322a) may include a first convex portion E2 convexly protruding in the thickness direction of the semiconductor device 10 (the Z-axis direction in the drawings). By isotropic etching in an etching process (e.g., a wet etching process) of removing the first interlayer sacrificial layer 130s, the first convex portions E2 may be formed at opposite side surfaces of the cover insulation layer 132c (e.g., the second cover portion or the second insulation portion 1322a). By the etching process of removing the first interlayer sacrificial layer 130s and/or a subsequent process, the first convex portion E2 may have a rounded shape, but the embodiments are not limited thereto.

In an embodiment, the cover insulation layer 132c may surround and protect the gate electrode 130 and/or the blocking layer 132j. In an embodiment, the cover insulation layer 132c may be formed and thereafter the blocking layer 132j and the gate electrode 130 may be sequentially formed. Accordingly, damage to the blocking layer 132j and/or the gate electrode 130 in a process of forming the cover insulation layer 132c may be fundamentally limited and/or prevented.

In an embodiment, in the thickness direction of the semiconductor device 10 (the Z-axis direction in the drawings), a length of the flat portion 154f may be greater than a length or a thickness of the gate electrode 130. For example, in the thickness direction of the semiconductor device 10, the entirety of the gate electrode 130 may correspond to or overlap the flat portion 154f having the substantially same thickness. This may be because the cover insulation layer 132c, the blocking layer 132j, and the gate electrode 130 are formed in a space in which the second interlayer sacrificial layer 132m is removed. Thereby, charges may be stably stored in the storage portion 154p due to a voltage applied to the gate electrode 130.

On the other hand, when a length of a portion of a storage portion having a same thickness is less than a length or a thickness of a gate electrode in a thickness direction of a semiconductor device, a portion of the storage portion corresponds to the gate electrode includes a portion in which a thickness varies, or the storage portion has a rounded shape or a bent shape, it may be difficult to stably store charges in the storage portion due to a voltage applied to the gate electrode. For example, when the separation process of separating a charge storage layer to a plurality of storage portions through a penetration part for a channel structure, unlike an embodiment, the storage portion may have a rounded shape or a bent shape.

In an embodiment, the cover insulation layer 132c (e.g., the first cover insulation layer 132a) may include a material different from a material of the first interlayer sacrificial layer 130s or the second layer 154, and may include or be formed of a material same as a material of the second interlayer sacrificial layer 132m, the first layer 152, or the third layer 156. For example, the cover insulation layer 132c may include or be formed of a material same as a material of the second interlayer sacrificial layer 132m to which the gate electrode 130 and the cover insulation layer 132c correspond together. For example, the cover insulation layer 132c (e.g., the first cover insulation layer 132a) may include or be formed of silicon oxide, silicon nitride, silicon oxynitride, a high dielectric constant material having a dielectric constant greater than a dielectric constant of silicon oxide, or a combination thereof. For example, the cover insulation layer 132c (e.g., the first cover insulation layer 132a) may include or be formed of oxide (e.g., silicon oxide). However, the embodiments are not limited thereto, and a material of the cover insulation layer 132c (e.g., the first cover insulation layer 132a) may be variously modified.

The blocking layer 132j may be disposed between the gate electrode 130 and the cover insulation layer 132c. The blocking layer 132j may include a first blocking portion 1321j and a second blocking portion 1322j. The first blocking portion 1321j may be disposed between the gate electrode 130 and the first insulation portion 1321a. The second blocking portion 1322j may be disposed between the gate electrode 130 and the second insulation portion 1322a. The blocking layer 132j may include a material different from a material of the cover insulation layer 132c (e.g., an insulating material different from a material of the cover insulation layer 132c). For example, the blocking layer 132j may include or be formed of silicon oxide, silicon nitride, silicon oxynitride, a high dielectric constant material having a dielectric constant greater than a dielectric constant of silicon oxide, or a combination thereof. However, the embodiments are not limited thereto, and the blocking layer 132j may include any of various materials.

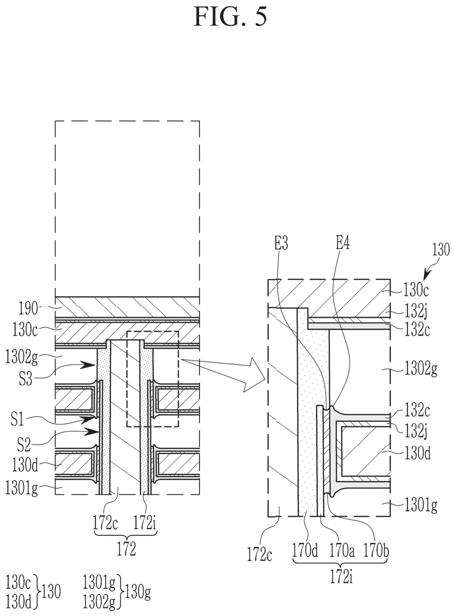

Referring to FIG. 5 together with FIG. 2 and FIG. 3, the gate contact 172 will be described in more detail. FIG. 5 is an enlarged view of a portion C in FIG. 3.

Referring to FIG. 2, FIG. 3 and FIG. 5, in an embodiment, the gate contact 172 may include a first conductive portion 172c and a first side insulation layer 172i. The first conductive portion 172c may be electrically connected to a connection gate electrode 130c of the plurality of gate electrodes 130. The first side insulation layer 172i may be disposed between the first conductive portion 172c and the gate stacking structure 120 on a side surface of the first conductive portion 172c.

In each gate contact 172, the first side insulation layer 172i may be disposed at least between a side surface of the first conductive portion 172c and a side surface of a penetrated gate electrode 130d, and may electrically insulate the first conductive portion 172c and the penetrated gate electrode 130d. Thereby, the first side insulation layer 172i may surround the entirety of the side surface of the first conductive portion 172c corresponding to the penetrated gate electrode 130d, and may stably electrically insulate the first conductive portion 172c and the penetrated gate electrode 130d. The first side insulation layer 172i may not be disposed between an end of the first conductive portion 172c and a surface of the connection gate electrode 130c adjacent to each other.

However, the embodiments are not limited thereto, and a position of the first side insulation layer 172i, a connection portion of the gate contact 172 and the connection gate electrode 130c, or the like may be variously modified.

For example, the first conductive portion 172c may have a pillar shape (e.g., a pillar shape having a planar shape of a circular shape, a polygonal shape, an oval shape, or the like), and the first side insulation layer 172i may have a ring shape, a frame shape, or the like surrounding the first conductive portion 172c.

For example, the first conductive portion 172c may include tungsten (W), titanium (Ti), tantalum (Ta), copper (Cu), aluminum (Al), cobalt (Co), or ruthenium (Ru), and may further a diffusion barrier layer. However, the embodiments are not limited thereto, and the first conductive portion 172c may include any of various materials.

For example, the first side insulation layer 172i may include or be formed of oxide (e.g., silicon oxide), oxynitride (e.g., silicon oxynitride), a low dielectric constant material having a dielectric constant lower than a dielectric constant of silicon oxide, or a combination thereof. However, the embodiments are not limited thereto, and the first side insulation layer 172i may include any of various materials.

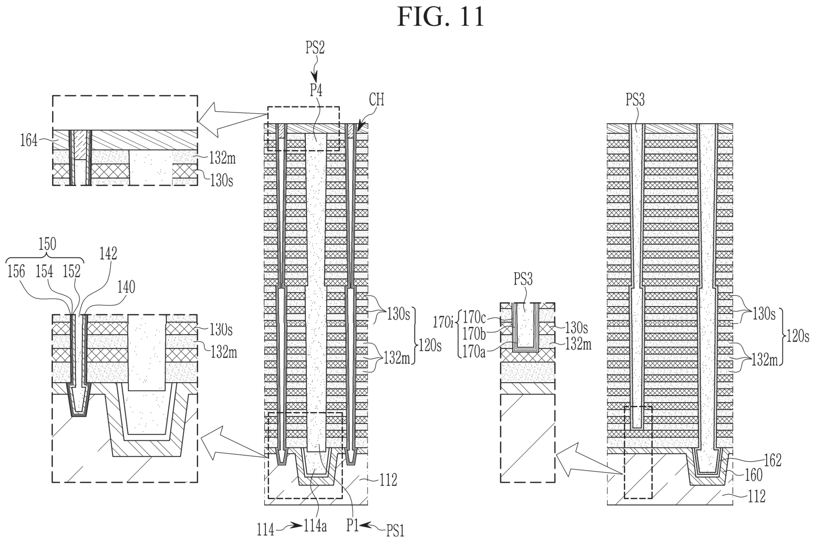

In an embodiment, the first side insulation layer 172i may include a plurality of layers. For example, the first side insulation layer 172i may include a first insulation layer 170a and a second insulation layer 170b that are sequentially disposed, and may further include an inner insulation layer 170d inside the first insulation layer 170a. In FIG. 5, it is illustrated as an example that the first side insulation layer 172i includes the first insulation layer 170a, the second insulation layer 170b, and the inner insulation layer 170d, and not include a third insulation layer 170c (refer to FIG. 11). In some embodiments, at least a portion of the third insulation layer 170c may remain between the second insulation layer 170b and the cover insulation layer 132c.

For example, the first insulation layer 170a may include or be formed of a material same as a material of the first layer 152, and the second insulation layer 170b may include or be formed of a material same as a material of the second layer 154, and the third insulation layer 170c may include or be formed of a material same as a material of the third layer 156. Thereby, the first layer 152 and the first insulation layer 170a may be removed by a same process, the second layer 154 and the second insulation layer 170b may be removed by a same process, and the third layer 156 and the third insulation layer 170c may be removed by a same process. When the first to third insulation layers 170a, 170b, and 170c of the first side insulation layer 172i have the same structure as the first to third layers 152, 154, and 156 of the gate dielectric layer 150 as in the above, a shape of a penetration part for the gate contact 172 may stably maintain in the two replacement processes of forming the gate stacking structure 120. However, the embodiments are not limited thereto.

In an embodiment, the first insulation layer 170a, the third insulation layer 170c, and the inner insulation layer 170d may include or be formed of a same material. The second insulation layer 170b may include a material different from a material of the first insulation layer 170a, the third insulation layer 170c, and the inner insulation layer 170d. However, the embodiments are not limited thereto. In some embodiments, at least two of the first insulation layer 170a, the third insulation layer 170c, and the inner insulation layer 170d may include different materials. For a clear understanding, FIG. 5 illustrates boundaries of the first insulation layer 170a, the second insulation layer 170b, and the inner insulation layer 170d. However, when the first insulation layer 170a and the inner insulation layer 170d may include or be formed of a same material, a boundary of the first insulation layer 170a and the inner insulation layer 170d may not be seen or confirmed.

For example, the first insulation layer 170a, the third insulation layer 170c, and/or the inner insulation layer 170d may include a material different from a material of the first interlayer sacrificial layer 130s, and may include or be formed of a material same as a material of the second interlayer sacrificial layer 132m. The second insulation layer 170b may include or be formed of a material same as a material of the first interlayer sacrificial layer 130s, and may include a material different from a material of the second interlayer sacrificial layer 132m.

For example, the first insulation layer 170a, the third insulation layer 170c, and/or the inner insulation layer 170d may include or be formed of oxide (e.g., silicon oxide). For example, the second insulation layer 170b may include or be formed of nitride (e.g., silicon nitride). However, the embodiments are not limited thereto, and the first insulation layer 170a, the second insulation layer 170b, the third insulation layer 170c, and the inner insulation layer 170d may include any of various insulating materials.

In an embodiment, the first side insulation layer 172i may include a first side portion S1, a second side portion S2, and a third side portion S3 having different stacking structures. For example, the third side portion S3 may have a stacking structure different from a stacking structure of at least one of the first side portion S1 and the second side portion S2.

In the thickness direction of the semiconductor device 10 (the Z-axis direction in the drawings), the first side portion S1 may include a portion corresponding to the gate electrode 130, the second side portion S2 may include a portion corresponding to at least a portion of a separated air gap layer 1301g that is spaced apart from the connection gate electrode 130c, and the third side portion S3 may include a portion corresponding to at least a portion of an adjacent air gap layer 1302g that is adjacent to the connection gate electrode 130c.

For example, the first side portion S1 may include the first insulation layer 170a, the second insulation layer 170b, and the inner insulation layer 170d. For example, the second side portion S2 may include the first insulation layer 170a and the inner insulation layer 170d without the second insulation layer 170b. The third side portion S3 may include the inner insulation layer 170d without the first insulation layer 170a and the second insulation layer 170b. For example, a thickness of the inner insulation layer 170d in the third side portion S3 may be greater than a thickness of the inner insulation layer 170d in the first side portion S1 and/or the second side portion S2. However, the embodiments are not limited thereto. In some embodiments, the inner insulation layer 170d may be disposed in the third side portion S3, and may not be disposed in the first side portion S1 and the second side portion S2. A manufacturing process of the first side insulation layer 172i will be described in more detail in a manufacturing method of the semiconductor device 10.

In an embodiment, the second insulation layer 170b may include a plurality of separation insulation portions spaced apart from each other to correspond to the plurality of gate electrodes 130, respectively. For example, the second insulation layer 170b may have a separated insulation structure. For example, the second insulation layer 170b extending in the vertical direction may have the separated insulation structure in which the plurality of insulation portions are separated to be spaced apart from each other in the vertical direction.

Each of opposite side surfaces of the separation insulation portion may include a second concave portion E3 recessed or depressed toward an inner side in the thickness direction of the semiconductor device 10 (the Z-axis direction in the drawings). For example, the second concave portion E3 of the separation insulation portion and the first concave portion E1 of the storage portion 154p of the second layer 154 may be formed by a same process (e.g., the separation process) and may have a same or similar shape. For example, by the second concave portion E3, a side surface of the separation insulation portion may be recesses or depressed in a central portion than in a portion adjacent to the first insulation layer 170a and a portion adjacent to the gate electrode 130.

In an embodiment, each of opposite side surfaces of a portion of the cover insulation layer 132c adjacent to the second insulation layer 170b may include a second convex portion E4 convexly protruding in the thickness direction of the semiconductor device 10 (the Z-axis direction in the drawings). For example, the second convex portion E4 of the separation insulation portion and the first convex portion E2 of the cover insulation layer 132c adjacent to the second layer 154 may be formed by a same process (e.g., the separation process) and may have a same or similar shape. For example, by isotropic etching in an etching process (e.g., a wet etching process) of removing the first interlayer sacrificial layer 130s, the second convex portions E4 may be formed at opposite side surfaces of the portion of the cover insulation layer 132c that is adjacent to the second insulation layer 170b. By the etching process of removing the first interlayer sacrificial layer 130s and/or a subsequent process, the second convex portion E4 may have a rounded shape, but the embodiments are not limited thereto.

In an embodiment, the gate contact 172 may include a connection portion 172a, and may further include an extension portion 172b. The connection portion 172a may pass through a portion of one of the plurality of gate stacking portions 121 and 122, and may be electrically connected to the connection gate electrode 130c. The extension portion 172b may pass through the entirety of one of the plurality of gate stacking portions 121 and 122. The connection portion 172a and/or the extension portion 172b may have an inclined side surface such that a width of the connection portion 172a and/or the extension portion 172b decreases toward the first surface 120a of the gate stacking structure 120 due to a high aspect ratio. A bent portion may be provided between the extension portion 172b and the connection portion 172a or between the extension portion 172b and the extension portion 172b at a boundary portion between the plurality of gate stacking portions 121 and 122.

For example, a gate contact 172 electrically connected to a gate electrode 130 included in the first gate stacking portion 121 may include an extension portion 172b passing through the second gate stacking portion 122, and a connection portion 172a passing through a portion of the first gate stacking portion 121 to be connected to the extension portion 172b. For example, a gate contact 172 electrically connected to a gate electrode 130 included in the second gate stacking portion 122 may include a connection portion 172a passing through a portion of the first gate stacking portion 121.

For example, the connection portion 172a may be disposed in a first etched portion formed by a first etching process, and the extension portion 172b may be disposed in a second etched portion formed by a second etching process. The first etching process may include a plurality of partial etching processes using a binary system. In the second etching process, penetration parts in which the channel structure CH, the dummy structure DH, the separation structure 146, and/or the input/output connection wiring 174 will be disposed may be formed. For example, the second etching process may be a high aspect ratio contact (HARC) etching process. Thereby, the second etched portion may be separately formed by using the second etching process, and a length of the first etched portion in which the connection portion 172a is disposed may be reduced.

However, the embodiments are not limited thereto, and each of the plurality of gate contacts 172 may include the connection portion 172a without the extension portion 172b. For example, the gate contact 172 may have an inclined side surface such that a width of the gate contact 172 decreases toward the first surface 120a of the gate stacking structure 120. The gate contact 172 may not include a bent portion at a boundary portion between the plurality of gate stacking portions 121 and 122.

For example, a gate contact 172 electrically connected to a gate electrode 130 included in the first gate stacking portion 121 may include a connection portion 172a passing through the entirety of the second gate stacking portion 122 and a portion of the first gate stacking portion 121. For example, a gate contact 172 electrically connected to a gate electrode 130 included in the second gate stacking portion 122 may include a connection portion 172a passing through a portion of the first gate stacking portion 121.

In an embodiment, the plurality of gate contacts 172 may be individually disposed in a plurality of penetration parts and the gate electrode 130 may be disposed in the entirety of the first region 106 of the connection region 104. Accordingly, an improved stability may be achieved in the two replacement processes of forming the gate stacking structure 120. For example, each of the plurality of gate contacts 172 may individually pass through the gate stacking structure 120 including the plurality of air gap layers 130g and the plurality of gate electrodes 130. For example, the air gap layer 130g may be disposed between the gate electrodes 130, and parasitic capacitance may be reduced and/or speed may be improved. The air gap layer 130g may have an improved insulating property, and a breakdown voltage may be improved and reliability of the semiconductor device 10 may be improved.

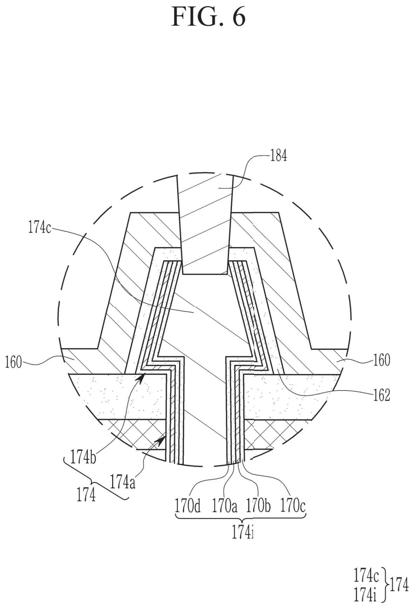

Referring to FIG. 6 together with FIG. 3, the input/output connection wiring 174 will be described in more detail. FIG. 6 is an enlarged view of a portion D in FIG. 3.

Referring to FIG. 3 and FIG. 6, in an embodiment, the input/output connection wiring 174 may include a second conductive portion 174c and a second side insulation layer 174i. The second side insulation layer 174i may be disposed between the second conductive portion 174c and the gate stacking structure 120 on a side surface of the second conductive portion 174c.

In each input/output connection wiring 174, the second side insulation layer 174i may be disposed at least on a side surface of the second conductive portion 174c, and may stably electrically insulate the second conductive portion 174c.

For example, the second conductive portion 174c may have a pillar shape (e.g., a pillar shape having a planar shape of a circular shape, a polygonal shape, an oval shape, or the like), and the second side insulation layer 174i may have a ring shape, a frame shape, or the like surrounding the second conductive portion 174c.

For example, the second conductive portion 174c may include or be formed of tungsten (W), titanium (Ti), tantalum (Ta), copper (Cu), aluminum (Al), cobalt (Co), or ruthenium (Ru), and may further include a diffusion barrier layer. However, the embodiments are not limited thereto, and the second conductive portion 174c may include any of various materials.

For example, the second side insulation layer 174i may include or be formed of oxide (e.g., silicon oxide), oxynitride (e.g., silicon oxynitride), a low dielectric constant material having a dielectric constant lower than a dielectric constant of silicon oxide, or a combination thereof. However, the embodiments are not limited thereto, and the second side insulation layer 174i may include any of various materials.

In an embodiment, the second side insulation layer 174i may include a plurality of layers. For example, the second side insulation layer 174i may include a first insulation layer 170a, a second insulation layer 170b, and a third insulation layer 170c that are sequentially disposed, and may further include an inner insulation layer 170d inside the first insulation layer 170a. For example, the description of materials of the first insulation layer 170a, the second insulation layer 170b, the third insulation layer 170c, and the inner insulation layer 170d, included in the first side insulation layer 172i may be applied to materials of the first insulation layer 170a, the second insulation layer 170b, the third insulation layer 170c, and the inner insulation layer 170d, included in the second side insulation layer 174i.

In an embodiment, the input/output connection wiring 174 may pass through the sacrificial stacking structure 120s. The first insulation layer 170a, the second insulation layer 170b, the third insulation layer 170c, and the inner insulation layer 170d, included in the input/output connection wiring 174, may remain without being removed in the two replacement processes of forming the gate stacking structure 120 or the separation process of forming the plurality of storage portions 154p. For example, the input/output connection wiring 174 may be formed using at least a portion of a process of forming the gate contact 172. Accordingly, it is illustrated and described as an example that the input/output connection wiring 174 has a structure or a shape same as or similar to a structure or a shape of the gate contact 172, expect that the first insulation layer 170a, the second insulation layer 170b, the third insulation layer 170c, and the inner insulation layer 170d, included in the input/output connection wiring 174, remain without being removed.

However, the embodiments are not limited thereto. In some embodiments, the input/output connection wiring 174 may pass through the gate stacking structure 120. The second side insulation layer 174i of the input/output connection wiring 174 may have a separation insulation structure or the like, as the first side insulation layer 172i of the gate contact 172. In some embodiments, the input/output connection wiring 174 may be formed by a process separated from a process of forming the gate contact 172, or may have a structure or shape different from a structure or shape of the gate contact 172.

In an embodiment, the input/output connection wiring 174 may include a wiring penetration portion 174a and a wiring expanded portion 174b. For example, the input/output connection wiring 174, which is a penetration structure, may include a penetration portion (e.g., the wiring penetration portion 174a) and an expanded portion (e.g., the wiring expanded portion 174b). The wiring penetration portion 174a may extend to pass through the gate stacking structure 120, and the wiring expanded portion 174b may be disposed on the first surface 120a of the stacking structure. The wiring expanded portion 174b may have a width or an area greater than a width or an area of the wiring penetration portion 174a. The width or the area of the wiring penetration portion 174a or the wiring expanded portion 174b may refer to a width (e.g., a long width or a diameter) or an area of a portion adjacent to the first surface 120a of the stacking structure. The wiring expanded portion 174b may correspond to a portion in which a first etch stopping pattern 114a (refer to FIG. 7) was disposed.

In an embodiment, a buffer layer 162 and a first protective layer 160 may be disposed on the wiring expanded portion 174b of the input/output connection wiring 174. The buffer layer 162 may limit and/or prevent undesirable removal of the first protective layer 160 in the two replacement processes of forming the gate stacking structure 120. The buffer layer 162 may include a material different from a material of the first protective layer 160. For example, the buffer layer 162 may include a material different from a material of the first interlayer sacrificial layer 130s, and may include or be formed of a material same as a material of the second interlayer sacrificial layer 132m. In the drawings, it is illustrated as an example that a first contact 184 (e.g., an input/output connection contact) passes through the first protective layer 160, the buffer layer 162, and the second side insulation layer 174i to be connected to the second conduction portion 174c. However, the embodiments are not limited thereto. In some embodiments, the buffer layer 162 may be removed in a manufacturing process and may not remain. Other various modified embodiments are possible.

In FIG. 3, it is illustrated as an example that the input/output connection wiring 174 (e.g., the wiring penetration portion 174a) has an inclined side surface such that a width of that the input/output connection wiring 174 (e.g., the wiring penetration portion 174a) decreases toward the first surface 120a of the stacking structure due to a high aspect ratio in a cross-sectional view. In FIG. 3, it is illustrated as an example that the input/output connection wiring 174 (e.g., the wiring penetration portion 174a) includes a bent portion at the boundary portion between the plurality of gate stacking portions 121 and 122. However, the embodiments are not limited thereto. The input/output connection wiring 174 may not include the bent portion at the boundary portion between the plurality of gate stacking portions 121 and 122. Other various modified embodiments are possible.

According to an embodiment, the second layer 154, which is the charge storage layer, may have the separated storage structure, and charge loss may be minimized. Further, the gate stacking structure 120 may include the air gap layer 130g, and parasitic capacitance may be reduced/or and a breakdown voltage may be improved. The cover insulation layer 132c may surround and protect the gate electrode 130 and the blocking layer 132j, and stability of the gate electrode 130 and the blocking layer 132j may be improved. Thereby, performance and reliability of the semiconductor device 10 may be improved. For example, the stacking structure may include the sacrificial stacking structure 120s and the gate stacking structure 120, and a form of the stacking structure may maximally maintain and performance and reliability of the semiconductor device 10 may be improved.

Hereinafter, referring to FIG. 7 to FIG. 27, a manufacturing method of a semiconductor device according to an embodiment will be described in detail. To the extent that an element is not described in detail below, it may be understood that the element is at least similar to a corresponding element that has been described elsewhere within the present disclosure. A portion which is not described in the above will be described in detail.

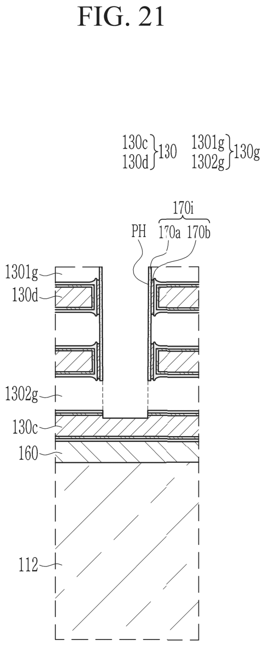

FIG. 7 to FIG. 27 are cross-sectional views illustrating a manufacturing method of a semiconductor device according to an embodiment. FIG. 7 and FIG. 10 illustrate a portion corresponding to FIG. 1. FIG. 11 to FIG. 20, FIG. 25 to FIG. 27 illustrate a portion corresponding to FIG. 3. FIG. 21 to FIG. 24 illustrate a portion corresponding to FIG. 5. Hereinafter, a manufacturing method of a semiconductor device will be described based on a stacking structure (e.g., a gate stacking structure 120 and a sacrificial stacking structure 120s), a channel structure CH, a separation structure 146, a gate contact 172, and an input/output connection wiring 174.

As illustrated in FIG. 7, a first protective layer 160, a buffer layer 162, and an etch stopping pattern 114 may be formed on or at a semiconductor substrate 112.

The semiconductor substrate 112 may include a semiconductor material. For example, the semiconductor substrate 112 may be a semiconductor substrate including or being formed of a semiconductor material or may be a semiconductor substrate in which a semiconductor layer is on a base substrate. For example, the semiconductor substrate 112 may include or be formed of a semiconductor material (e.g., silicon, germanium, silicon-germanium, or the like) having a single-crystalline, epitaxial, or polycrystalline structure, or may include or be formed of silicon on insulator (SOI), germanium on insulator (GOI), or the like.

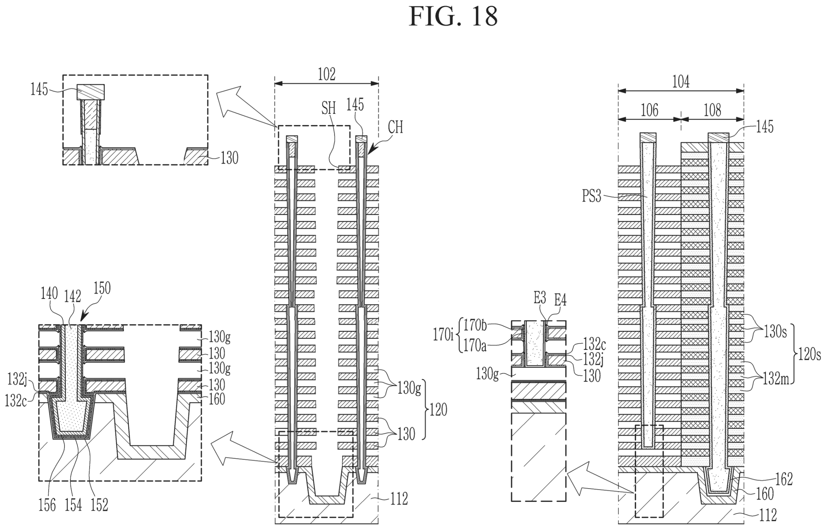

In a process of forming a gate stacking structure 120 (refer to FIG. 18), the first protective layer 160 may protect the semiconductor substrate 112, and the buffer layer 162 may protect the first protective layer 160. For example, the first protective layer 160 may include a material different from a material of a third interlayer sacrificial layer 130p (refer to FIG. 14) and/or the semiconductor substrate 112, and may protect the semiconductor substrate 112 in a process of removing the third interlayer sacrificial layer 130p. For example, the buffer layer 162 may include a material different from a material of the first interlayer sacrificial layer 130s and/or the first protective layer 160, and may protect the first protective layer 160 in a process of removing the first interlayer sacrificial layer 130s.

The etch stopping pattern 114 may include a first etch stopping pattern 114a on the first protective layer 160 and/or the buffer layer 162 and a second etch stopping pattern 114b passing through the first protective layer 160. For example, a first trench T1 may be formed in a portion of the semiconductor substrate 112 where the first etch stopping pattern 114a will be disposed, and thereafter, the first protective layer 160 and the buffer layer 162 may be formed. For example, a second trench T2 may be formed in a portion of the semiconductor substrate 112 where the second etch stopping pattern 114b will be disposed. Thereafter, the first trench T1 and the second trench T2 may be filled with a filling material to form the first etch stopping pattern 114a and the second etch stopping pattern 114b.

The first protective layer 160 may be disposed on the entirety of an inner surface of the first trench T1 and a surface (an upper surface in FIG. 7) of the semiconductor substrate 112, and the buffer layer 162 may be disposed in the first trench T1 on the first protective layer 160. The first etch stopping pattern 114a may be disposed in the first trench T1 on the first protective layer 160 and the buffer layer 162. The second etch stopping pattern 114b may be disposed in the second trench T2 that passes through the first protective layer 160 and is disposed in the semiconductor substrate 112.

The process of forming the first trench T1 or the second trench T2 may be performed by any of various processes (e.g., an etching process or the like). The process of forming the first protective layer 160 or the buffer layer 162 may be performed by any of various processes (e.g., a deposition process or the like). The process of filling the first trench T1 and the second trench T2 with the filling material may be performed by any of various processes (e.g., a deposition process or the like). After the process of filling the first trench T1 and the second trench T2 with the filling material, a process (e.g., a chemical mechanical polishing process or the like) of planarizing a surface of the semiconductor substrate 112 may be further performed.

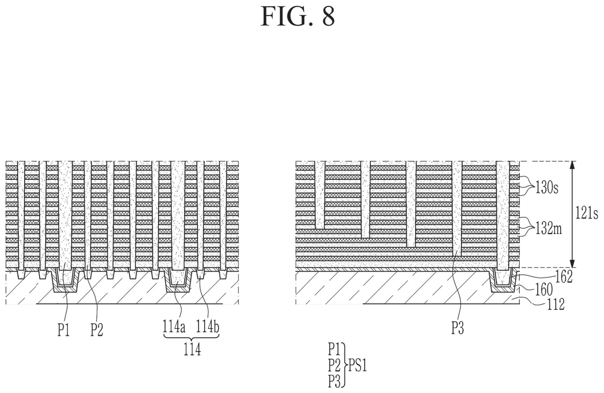

In a plan view, the etch stopping pattern 114 may be disposed to correspond to a portion in which at least one of a plurality of first penetration sacrificial layers PS1 (refer to FIG. 8) will be disposed. Each etch stopping pattern 114 may have a shape corresponding to a shape of each first penetration sacrificial layer PS1, and may have a width or an area greater than a width or an area of the first penetration sacrificial layer PS1.

The etch stopping pattern 114 (e.g., the filling material) may include or be formed of at least one of a semiconductor material (e.g., polycrystalline silicon), metal (e.g., tungsten), metal nitride (e.g., tungsten nitride or titanium nitride), and carbon. The etch stopping pattern 114 may include a single layer or a plurality of layers. In an embodiment, a barrier layer may be further included between the etch stopping pattern 114 and the buffer layer 162. For example, the barrier layer may include or be formed of a metallic material (e.g., tungsten (W), copper (Cu), aluminum (Al), or the like), polycrystalline silicon, metal nitride (e.g., titanium nitride (TiN), tantalum nitride (TaN), or the like), or a combination thereof. However, the embodiments are not limited thereto, and the etch stopping pattern 114 may include any of various materials.

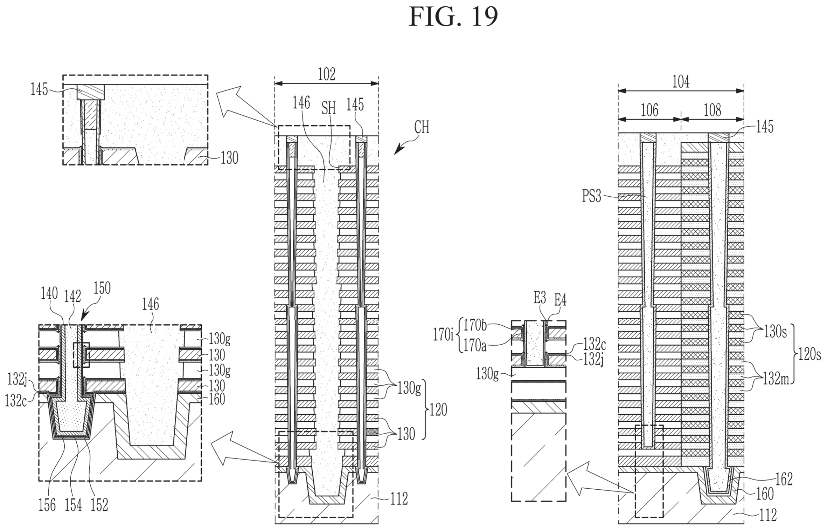

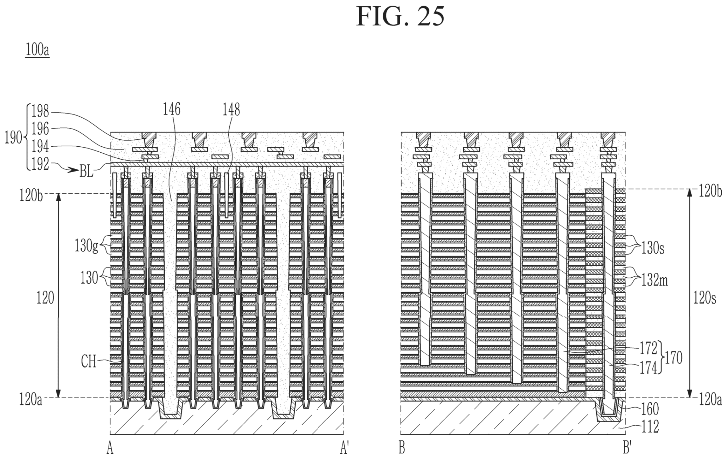

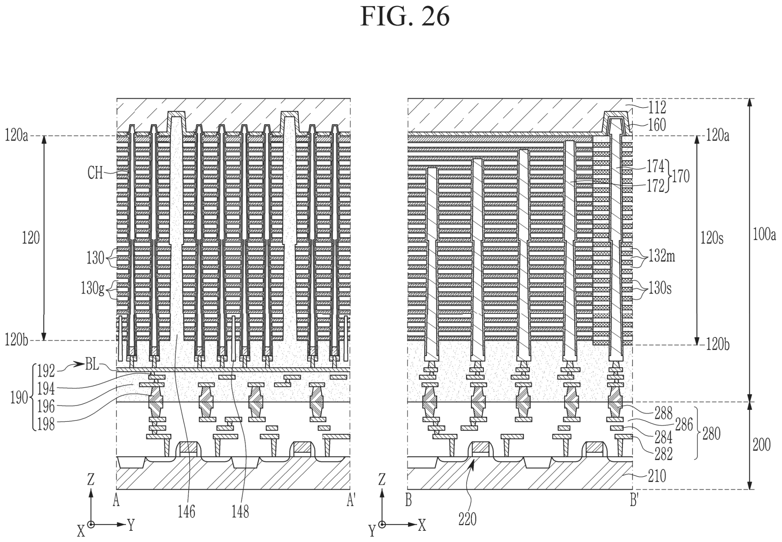

The first etch stopping pattern 114a may be disposed in portions in which a separation structure 146 (refer to FIG. 19), a dummy structure DH (refer to FIG. 2), an input/output connection wiring 174 (refer to FIG. 25) will be disposed. The second etch stopping pattern 114b may be disposed in portions in which a channel structure CH (refer to FIG. 10) will be disposed. Thereby, a subsequent process (refer to FIG. 26) of removing a portion of a gate dielectric layer 150 (refer to FIG. 10) in a channel expanded portion may be easily performed. However, the embodiments are not limited thereto. In some embodiments, the first etch stopping pattern 114a may be disposed in a portion in which the channel structure CH will be disposed, and the second etch stopping pattern 114b may be disposed in portions in which the separation structure 146, the dummy structure DH, and/or the input/output connection wiring 174 will be disposed. In some embodiments, the etch stopping pattern 114 may not be disposed in portions in which the channel structure CH, the separation structure 146, the dummy structure DH, and/or the input/output connection wiring 174 will be disposed.

For example, the first etch stopping pattern 114a corresponding to the separation structure 146 may have a shape longitudinally extending in a first direction in a plan view. In some embodiments, the first etch stopping pattern 114a corresponding to the separation structure 146 may include a plurality of first etch stopping patterns 114a that are spaced apart from each other in the first direction and each corresponds to a portion of the separation structure 146.

In FIG. 7, it is illustrated as an example that the first etch stopping patterns 114a corresponding to the separation structure 146 and the input/output connection wiring 174 have a same size (e.g., a same cross-sectional area), and the second etch stopping pattern 114b corresponding to the channel structure CH has a size (e.g., a cross-sectional area) less than a size (e.g., a cross-sectional area) of the first etch stopping pattern 114a. However, the embodiments are not limited thereto. In some embodiments, the first etch stopping patterns 114a corresponding to the separation structure 146 and the input/output connection wiring 174 may have different sizes (e.g., different cross-sectional areas), or the second etch stopping pattern 114b may have a size (e.g., a cross-sectional area) same as or greater than a size (e.g., a cross-sectional area) of the first etch stopping pattern 114a.

Subsequently, as illustrated in FIG. 8, a first sacrificial stacking portion 121s may be formed on the semiconductor substrate 112, and a first penetration sacrificial layer PS1 may be formed to pass through the first sacrificial stacking portion 121s.

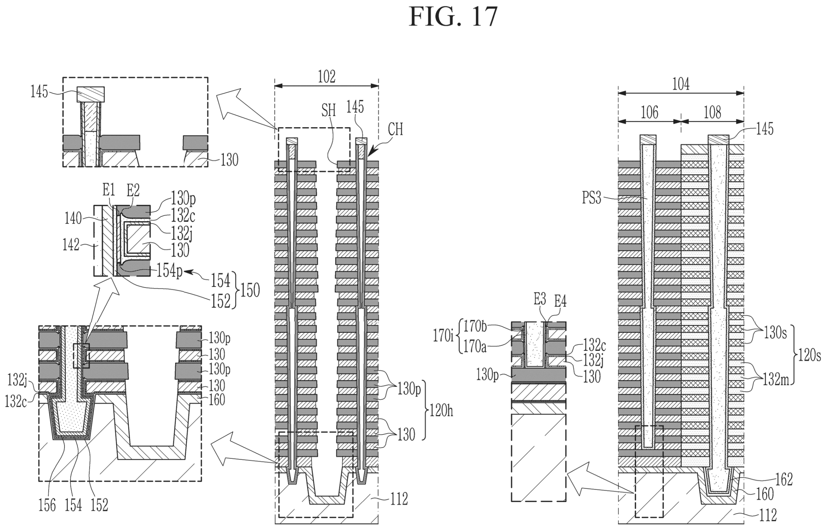

For example, a first interlayer sacrificial layer 130s and a second interlayer sacrificial layer 132m may be alternately stacked to each other on the semiconductor substrate 112 and/or the first protective layer 160 to form a first sacrificial stacking portion 121s. In an embodiment, the first interlayer sacrificial layer 130s may be replaced with a third interlayer sacrificial layer 130p (refer to FIG. 14) through a subsequent process and the third interlayer sacrificial layer 130p may be removed to form an air gap layer 130g (refer to FIG. 18). The second interlayer sacrificial layer 132m may be replaced with a gate structure (e.g., a cover insulation layer 132c (refer to FIG. 17), a gate electrode 130 (refer to FIG. 17), and/or a blocking layer 132j (refer to FIG. 17)) through a subsequent process. For example, the first interlayer sacrificial layer 130s may be formed to include a portion in which the air gap layer 130g will be disposed, and the second interlayer sacrificial layer 132m may be formed to include a portion in which at least a portion of the gate structure will be formed.

The first interlayer sacrificial layer 130s or the second interlayer sacrificial layer 132m may be formed by any of various processes (e.g., a deposition process or the like).

Subsequently, a first penetration sacrificial layer PS1 may be formed by forming a first penetration portion in a portion in which the first penetration sacrificial layer PS1 will be disposed and filling the first penetration portion with a sacrificial material. The process of forming the first penetration portion may be performed by any of various processes (e.g., an etching process or the like). The process filling the first penetration portion with the sacrificial material may be performed by any of various processes (e.g., a deposition process or the like). The first penetration sacrificial layer PS1 (e.g., the sacrificial material) may include or be formed of at least one of a semiconductor material (e.g., polycrystalline silicon), metal (e.g., tungsten), metal nitride (e.g., tungsten nitride or titanium nitride), and carbon. For example, the first penetration sacrificial layer PS1 may include a material same as or different from a material of the etch stopping pattern 114.

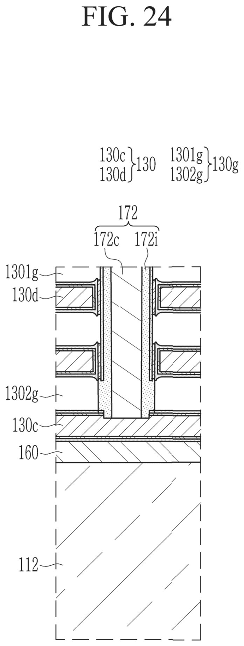

The first penetration sacrificial layer PS1 may include a first sacrificial portion P1, a second sacrificial portion P2, and a third sacrificial portion P3. The first sacrificial portion P1 may pass through the entirety of the first sacrificial stacking portion 121s and may reach the first etch stopping pattern 114a. The second sacrificial portion P2 may pass through the entirety of the first sacrificial stacking portion 121s, and may reach the second etch stopping pattern 114b. The third sacrificial portion P3 may pass through a portion of the first sacrificial stacking portion 121s. For example, the first sacrificial portion P1 may be disposed in a portion in which the separation structure 146, the dummy structure DH, and the input/output connection wiring 174 will be disposed. The second sacrificial portion P2 may be disposed in a portion in which the channel structure CH will be disposed. The third sacrificial portion P3 may be disposed in a portion in which a connection portion 172a (refer to FIG. 3) of a gate contact 172 (refer to FIG. 24) 172) will be disposed.

An end of the first sacrificial portion P1 and/or an end of the second sacrificial portion P2 may be disposed in the etch stopping pattern 114. The etch stopping pattern 114 may have a width or an area greater than a width or an area of the first sacrificial portion P1 and/or the second sacrificial portion P2 as described in the above, and the entirety of the end of the first sacrificial portion P1 and/or the second sacrificial portion P2 may be stably disposed in the etch stopping pattern 114.

For example, the first penetration portions in which the first sacrificial portion P1 and the second sacrificial portion P2 are disposed may be a second etched portion formed by a second etching process (e.g., a high aspect ratio contact etching process). However, the embodiments are not limited thereto.

For example, the first penetration portion in which the third sacrificial portion P3 is disposed may be a first etched portion formed by a first etching process (e.g., a plurality of partial etching processes using a binary system). For example, a position (e.g., a position or a level in a vertical direction) of the first interlayer sacrificial layer 130s may be converted using a binary system, and the plurality of partial etching processes of etching 1, 2, 4,..., 2⁽ⁿ⁻¹⁾ of the first interlayer sacrificial layer(s) 130s and/or the second interlayer sacrificial layer(s) 132m may be performed. Thereby, a plurality of first penetration portions (e.g., a plurality of first etched portions) having different depths may be formed.

For example, first penetration portions corresponding to the first sacrificial portion P1 and the second sacrificial portion P2 may be formed, and thereafter, a first penetration portion corresponding to the third sacrificial portion P3 may be formed. In some embodiments, a first penetration portion corresponding to the third sacrificial portion P3 may be formed, and thereafter, first penetration portions corresponding to the first sacrificial portion P1 and the second sacrificial portion P2 may be formed. In some embodiments, first penetration portions corresponding to the first sacrificial portion P1, the second sacrificial portion P2 and the third sacrificial portion P3 may be separately formed. Other various modified embodiments are possible.

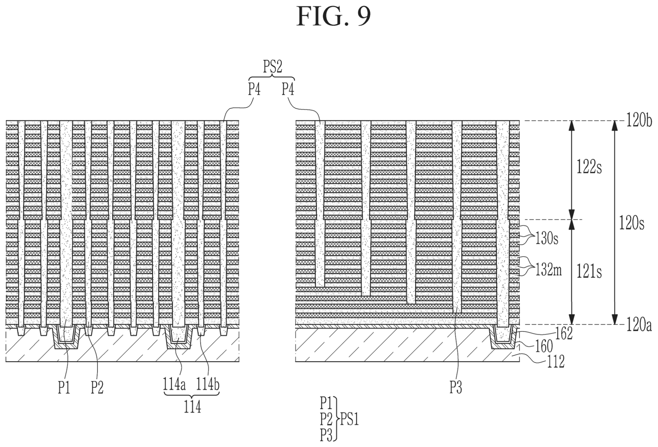

Subsequently, as illustrated in FIG. 9, a second sacrificial stacking portion 122s may be formed to form a sacrificial stacking structure 120s, and a second penetration sacrificial layer PS2 passing through the second sacrificial stacking portion 122s may be formed.

The description on the first interlayer sacrificial layer 130s and/or the second interlayer sacrificial layer 132m of the first sacrificial stacking portion 121s may be applied to the first interlayer sacrificial layer 130s and/or the second interlayer sacrificial layer 132m of the second sacrificial stacking portion 122s.

The second penetration sacrificial layer PS2 may be formed by forming a second penetration portion in a portion in which the second penetration sacrificial layer PS2 will be disposed and filling the second penetration portion with a sacrificial material. The process of forming the second penetration portion may be performed by any of various processes (e.g., an etching process or the like). The process of filling the second penetration portion with the sacrificial material may be performed by any of various processes (e.g., a deposition process or the like). The second penetration sacrificial layer PS2 may include or be formed of at least one of a semiconductor material (e.g., polycrystalline silicon), metal (e.g., tungsten), metal nitride (e.g., tungsten nitride or titanium nitride), and carbon. For example, the second penetration sacrificial layer PS2 may include a material same as or different from a material of the etch stopping pattern 114 and/or the first penetration sacrificial layer PS1.

The second penetration sacrificial layer PS2 may include a fourth sacrificial portion P4 and a fifth sacrificial portion. The fourth sacrificial portion P4 may pass through the entirety of the second sacrificial stacking portion 122s. The fifth sacrificial portion may pass through a portion of the second sacrificial stacking portion 122s. The fourth sacrificial portion P4 may be disposed in a portion in which the channel structure CH, the separation structure 146, the dummy structure DH, the input/output connection wiring 174, and an extension portion 172b (refer to FIG. 3) of the gate contact 172 will be disposed. The fifth sacrificial portion may be disposed in a portion in which the connection portion 172a of the gate contact 172 will be disposed.

In an embodiment, the second penetration portion in which the fourth sacrificial portion P4 is disposed may be a second etched portion formed by a second etching process (e.g., a high aspect ratio contact etching process). The second penetration portion in which the fifth sacrificial portion is disposed may be a first etched portion formed by a first etching process (e.g., a plurality of partial etching processes using a binary system). However, the embodiments are not limited thereto.

In an embodiment, the sacrificial stacking structure 120s may include the first sacrificial stacking portion 121s and the second sacrificial stacking portion 122s sequentially stacked to each other on the semiconductor substrate 112 and/or the first protective layer 160. However, the embodiments are not limited thereto, and the sacrificial stacking structure 120s may include a single sacrificial stacking portion or three or more sacrificial stacking portions.

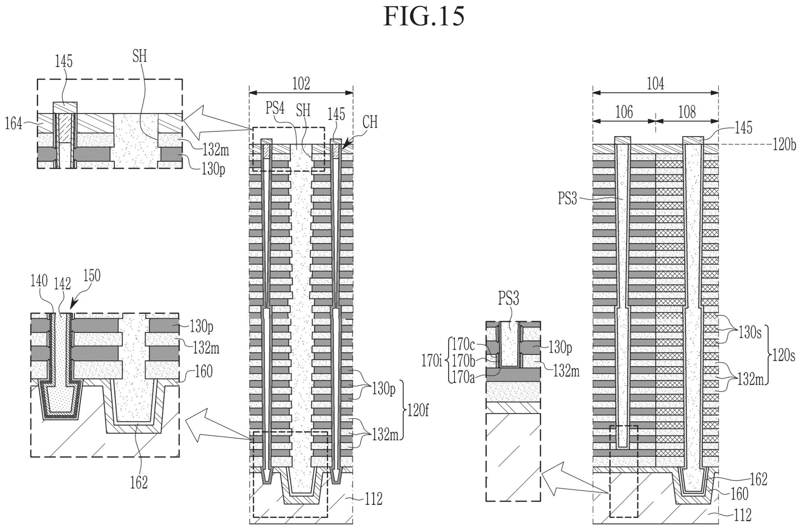

Subsequently, as illustrated in FIG. 10, a channel structure CH may be formed. In the process of forming the channel structure CH, a dummy structure DH (refer to FIG. 2) may be formed together. For example, the channel structure CH and the dummy structure DH may have a state not including a second protective layer 145 (refer to FIG. 15).

For example, a first mask layer 164 may be formed, and a preliminary penetration portion may be formed through an opening of the first mask layer 164. For example, a penetration part for a channel structure may be formed by removing the first penetration sacrificial layer PS1 (e.g., the second sacrificial portion P2 (refer to FIG. 9)), the second penetration sacrificial layer PS2 (e.g., the fourth sacrificial portion P4), and the etch stopping pattern 114 (e.g., the second etch stopping pattern 114b (refer to FIG. 9)) in a portion in which the channel structure CH will disposed. For example, a penetration part for a dummy structure may be formed together by removing the first penetration sacrificial layer PS1 (e.g., the first sacrificial portion P1), the second penetration sacrificial layer PS2 (e.g., the fourth sacrificial portion P4), and the etch stopping pattern 114 (e.g., the first etch stopping pattern 114a) in a portion in which the dummy structure DH will be disposed.

The first mask layer 164 may include or be formed of a material same as a material of the second interlayer sacrificial layer 132m, or include oxide (e.g., silicon oxide). For example, the first mask layer 164 may include a material different from a material of the first interlayer sacrificial layer 130s. Thereby, the first mask layer 164 may not be separately removed after the channel structure CH is formed, and may be removed together with the second interlayer sacrificial layer 132m in a process of removing the second interlayer sacrificial layer 132m. However, the embodiments are not limited thereto.

The channel structure CH may be formed in the penetration part for the channel structure. For example, a gate dielectric layer 150, a channel layer 140, a core insulation layer 142, and a channel pad 144 may be sequentially formed in the penetration part for the channel structure. For example, the gate dielectric layer 150 may be formed by sequentially forming a third layer 156, a second layer 154, and a first layer 152. The process of forming the gate dielectric layer 150, the channel layer 140, the core insulation layer 142, or the channel pad 144 may be performed by any of various processes (e.g., a deposition process or the like).

The dummy structure DH may be formed in the penetration part for the dummy structure. For example, the dummy structure DH may be formed by forming a layer included in the channel structure CH in the penetration part for the dummy structure,. In some embodiments, the dummy structure DH may be formed by filling the penetration part for the dummy structure with any of various materials (e.g., an insulating material or the like), separated from the channel structure CH. In some embodiments, a portion of the dummy structure DH may be formed by using the first penetration sacrificial layer PS1, the second penetration sacrificial layer PS2, and/or the etch stopping pattern 114 (e.g., the sacrificial material or the filling material) that was disposed in the penetration part for the dummy structure. Other various modified embodiments are possible.

The process of removing the first penetration sacrificial layer PS1, the second penetration sacrificial layer PS2, and/or the etch stopping pattern 114 may be performed by any of various processes (e.g., an etching process or the like). The process of forming a layer included in the channel structure CH and/or the dummy structure DH may be performed by any of various processes (e.g. a deposition process or the like).

Subsequently, as illustrated in FIG. 11, a preliminary side insulation layer 170i and a third penetration sacrificial layer PS3 may be formed in a portion corresponding to the gate contact 172 and/or the input/output connection wiring 174.

For example, a mask layer may be formed, and a preliminary penetration part may be formed through an opening of the mask layer. For example, a penetration part for a gate contact may be formed by removing the first penetration sacrificial layer PS1 (e.g., the third sacrificial portion P3 (refer to FIG. 10)) and the second penetration sacrificial layer PS2 (e.g., the fourth sacrificial portion P4 and the fifth sacrificial portion) in a portion in which the gate contact 172 will be disposed. For example, a penetration part for an input/output wiring may be formed together by removing the first penetration sacrificial layer PS1 (e.g., the first sacrificial portion P1), the second penetration sacrificial layer PS2 (e.g., the fourth sacrificial portion P4), and the etch stopping pattern 114 (e.g., the first etch stopping pattern 114a) in a portion in which the input/output connection wiring 174 will be disposed.

The preliminary side insulation layer 170i and the third penetration sacrificial layer PS3 may be formed in the penetration part for the gate contact and/or the penetration part for the input/output wiring. For example, in the penetration part for the gate contact, the preliminary side insulation layer 170i may be formed by sequentially forming a third insulation layer 170c, a second insulation layer 170b, and a first insulation layer 170a, and thereafter, the third penetration sacrificial layer PS3 may be formed thereon. For example, in the penetration part for the input/output wiring, the preliminary side insulation layer 170i may be formed by sequentially forming the third insulation layer 170c, the second insulation layer 170b, and the first insulation layer 170a, and thereafter, the third penetration sacrificial layer PS3 may be formed thereon.

The third penetration sacrificial layer PS3 may include or be formed of at least one of a semiconductor material (e.g., polycrystalline silicon), metal (e.g., tungsten), metal nitride (e.g., tungsten nitride or titanium nitride), and carbon. For example, the third penetration sacrificial layer PS3 may include or be formed of a material same as or different from a material of the etch stopping pattern 114, the first penetration sacrificial layer PS1, and/or the second penetration sacrificial layer PS2.

The process of removing the first penetration sacrificial layer PS1, the second penetration sacrificial layer PS2, and/or the etch stopping pattern 114 may be performed by any of various processes (e.g., an etching process or the like). The process of forming the first insulation layer 170a, the second insulation layer 170b, the third insulation layer 170c, or the third penetration sacrificial layer PS3 may be performed by any of various processes (e.g., a deposition process or the like).

After the penetration part for the gate contact, the penetration part for the input/output wiring, and/or the third penetration sacrificial layer PS3 is formed, the mask layer may be removed. The process of removing the mask layer may be performed by any of various processes (e.g., an etching process, a chemical mechanical polishing process, or the like).

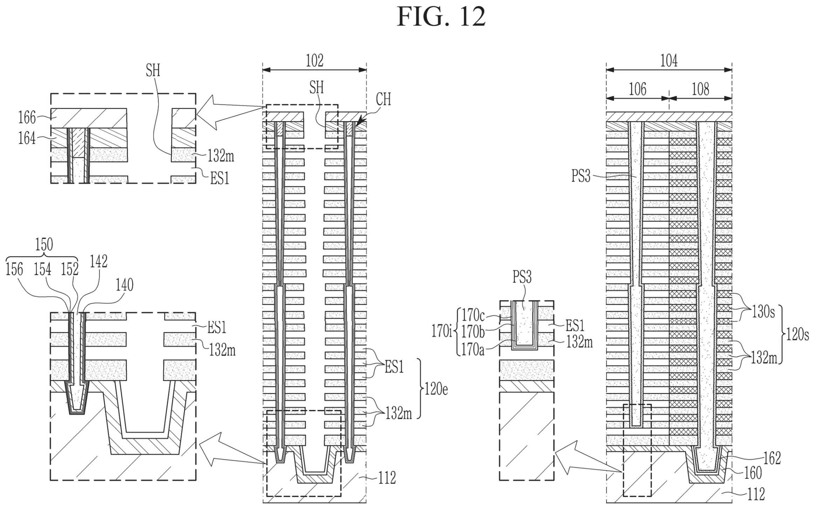

Subsequently, as illustrated in FIG. 12, in a cell array region 102 and a first region 106, the first interlayer sacrificial layer 130s may be selectively removed. The first interlayer sacrificial layer 130s in a second region 108 may remain without being removed. Thereby, in the cell array region 102 and the first region 106, a first stacking structure 120e including a plurality of second interlayer sacrificial layers 132m while interposing a first space ES1 therebetween may be disposed. The first space ES1 may be formed by an empty space. In the second region 108, the sacrificial stacking structure 120s including the first interlayer sacrificial layer 130s and the second interlayer sacrificial layer 132m may remain.

For example, a penetration part SH for a separation structure that corresponds to the separation structure 146 may be formed, and an etching process may be performed in a horizontal direction through the penetration part SH for the separation structure. Thereby, the first interlayer sacrificial layer 130s may be selectively removed in the cell array region 102 and the first region 106. For example, in the process of removing the first interlayer sacrificial layer 130s, the buffer layer 162 may protect the first protective layer 160. The process of removing the first interlayer sacrificial layer 130s may be performed by any of various processes (e.g., a wet etching process or the like).

For example, a second mask layer 166 may be formed, and the penetration part SH for the separation structure may be formed through an opening of the second mask layer 166. For example, the penetration part SH for the separation structure may be formed by removing the first penetration sacrificial layer PS1 (refer to FIG. 11), the second penetration sacrificial layer PS2 (refer to FIG. 11), and the etch stopping pattern 114 (refer to FIG. 11) in a portion in which the separation structure 146 will be disposed.

The second mask layer 166 may include a material different from a material of the first interlayer sacrificial layer 130s. For example, the second mask layer 166 may include or be formed of a material same as a material of the first mask layer 164 or the second interlayer sacrificial layer 132m, or include oxide (e.g., silicon oxide). However, the embodiments are not limited thereto, and the second mask layer 166 may include a material different from a material of the first mask layer 164 or the second interlayer sacrificial layer 132m, or include a material other than oxide. However, the embodiments are not limited thereto. The second mask layer 166 may be removed before a second protective layer 145 (refer to FIG. 15) is formed.

In an embodiment, it is described as an example that the etch stopping pattern 114, the first penetration sacrificial layer PS1, and the second penetration sacrificial layer PS2 corresponding to the separation structure 146 are formed and thereafter the etch stopping pattern 114, the first penetration sacrificial layer PS1, and the second penetration sacrificial layer PS2 are removed to form the penetration part SH for the separation structure. However, the embodiments are not limited thereto. In some embodiments, the etch stopping pattern 114, the first penetration sacrificial layer PS1, and the second penetration sacrificial layer PS2 corresponding to the separation structure 146 may not be formed, and the penetration part SH for the separation structure may be formed by an etching process performed after the sacrificial stacking structure 120s is formed.

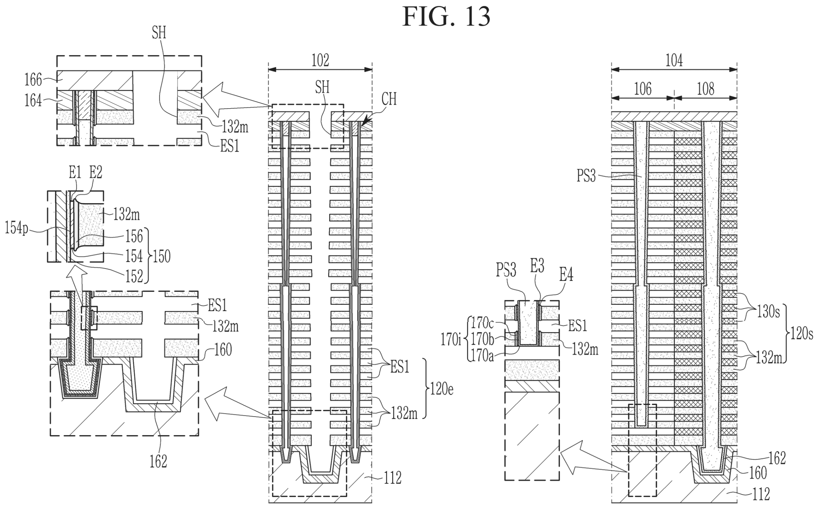

Subsequently, as illustrated in FIG. 13, a separation process may be performed. In the separation process, a portion of the third layer 156 and a portion of the second layer 154 disposed between the plurality of second interlayer sacrificial layers 132m in the channel structure CH may be removed. Thereby, the second layer 154, which is a charge storage layer, may have a separated storage structure including a plurality of storage portions 154p.

For example, in the separation process, the process of removing the portion of the third layer 156 disposed between the plurality of second interlayer sacrificial layers 132m and the process of removing the portion of the second layer 154 disposed between the plurality of second interlayer sacrificial layers 132m may be sequentially performed. The process of removing the portion of the third layer 156 or the second layer 154 may be performed by any of various processes (e.g., a wet etching process or the like).

In the process of removing the third layer 156, a first convex portion E2 may be formed at a side portion of the third layer 156 in a portion adjacent to the second layer 154. For example, opposite side surfaces of the third layer 156 may remain without being etched by isotropic etching in the process (e.g., a wet etching process) of removing the portion of the third layer 156 to form first convex portions E2.

In the process of removing the second layer 154, the second layer 154 may be removed using the third layer 156 as a mask. For example, the second layer 154 may be over-etched such that the second layer 154 stably has the separated storage structure. Thereby, first concave portions E1 may be formed at opposite side surfaces of the second layer 154.

In an embodiment, the second layer 154 may include or be formed of a material same as a material of the first interlayer sacrificial layer 130s, and may include a material different from a material of the second interlayer sacrificial layer 132m. After the first interlayer sacrificial layer 130s is removed, in a state that the second interlayer sacrificial layer 132m including a material different from a material of the second layer 154 remain, the separation process may be performed. Therefore, in the process of removing the portion of the second layer 154 (e.g., in the process of over-etching the second layer 154), the second interlayer sacrificial layer 132m may stably remain. Unlike the above, if the separation process is performed in a state that the first interlayer sacrificial layer 130s remains, in the process of removing the portion of the second layer 154 (e.g., in the process of over-etching the second layer 154), the first interlayer sacrificial layer 130s including or being formed of a material same as a material of the second layer 154 may be undesirably etched or damaged.

In an embodiment, by the separation process, portions of the third insulation layer 170c and the second insulation layer 170b of the preliminary side insulation layer 170i disposed between the plurality of second interlayer sacrificial layers 132m may be removed together. For example, a portion of the third insulation layer 170c disposed between the plurality of second interlayer sacrificial layers 132m may be removed together in the process of removing the portion of the third layer 156 disposed between the plurality of second interlayer sacrificial layers 132m. For example, a portion of the second insulation layer 170b disposed between the plurality of second interlayer sacrificial layers 132m may be removed together in the process of removing the portion of the second layer 154 disposed between the plurality of second interlayer sacrificial layers 132m.

In the process of removing the third insulation layer 170c, a second convex portion E4 corresponding to the first convex portion E2 may be formed at a side portion of the third insulation layer 170c in a portion adjacent to the second insulation layer 170b. Second concave portions E3 corresponding to the first concave portions E1 may be formed at opposite side surfaces of the second insulation layer 170b.

Subsequently, as illustrated in FIG. 14, in the cell array region 102 and the first region 106, a third interlayer sacrificial layer 130p may be formed in a portion in which the first interlayer sacrificial layer 130s is removed. Thereby, in the cell array region 102 and the first region 106, a second stacking structure 120f including the second interlayer sacrificial layers 132m and the third interlayer sacrificial layers 130p alternately disposed to each other may be disposed. In the second region 108, the sacrificial stacking structure 120s including the first interlayer sacrificial layers 130s and the second interlayer sacrificial layers 132m may remain.

The third interlayer sacrificial layer 130p may include a material different from a material of the first interlayer sacrificial layer 130s and a material of the second interlayer sacrificial layer 132m. For example, the third interlayer sacrificial layer 130p may include or be formed of a semiconductor material (e.g., polycrystalline silicon) or the like. However, the embodiments are not limited thereto. The process of forming the third interlayer sacrificial layer 130p may be performed by any of various processes (e.g., a deposition process or the like).

The third interlayer sacrificial layer 130p in the penetration part SH for the separation structure may be removed such that the third interlayer sacrificial layer 130p is disposed between the second interlayer sacrificial layers 132m. A fourth penetration sacrificial layer PS4 may be formed in the penetration part SH for the separation structure. The fourth penetration sacrificial layer PS4 may limit and/or prevent a second protective layer 145 (refer to FIG. 15) from being formed in the penetration part SH for the separation structure in a process of forming the second protective layer 145.

The fourth penetration sacrificial layer PS4 may include or be formed of at least one of a semiconductor material (e.g., polycrystalline silicon), metal (e.g., tungsten), metal nitride (e.g., tungsten nitride or titanium nitride), and carbon. For example, the fourth penetration sacrificial layer PS4 may include or be formed of a material same as or different from a material of the etch stopping pattern 114 (refer to FIG. 11), the first penetration sacrificial layer PS1 (refer to 11), the second penetration sacrificial layer PS2 (refer to FIG. 11), and/or the third penetration sacrificial layer PS3. For example, the fourth penetration sacrificial layer PS4 may include a material different from a material of the third interlayer sacrificial layer 130p, but the embodiments are not limited thereto.

Subsequently, as illustrated in FIG. 15, a second protective layer 145 may be formed on the channel structure CH and the third penetration sacrificial layer PS3 on a second surface 120b of a stacking structure. For example, a preliminary protective layer may be formed on the entirety of the second surface 120b of the stacking structure and a patterning process may be performed to form the second protective layer 145 on a portion corresponding to the channel structure CH and/or on the third penetration sacrificial layer PS3 and the preliminary side insulation layer 170i.

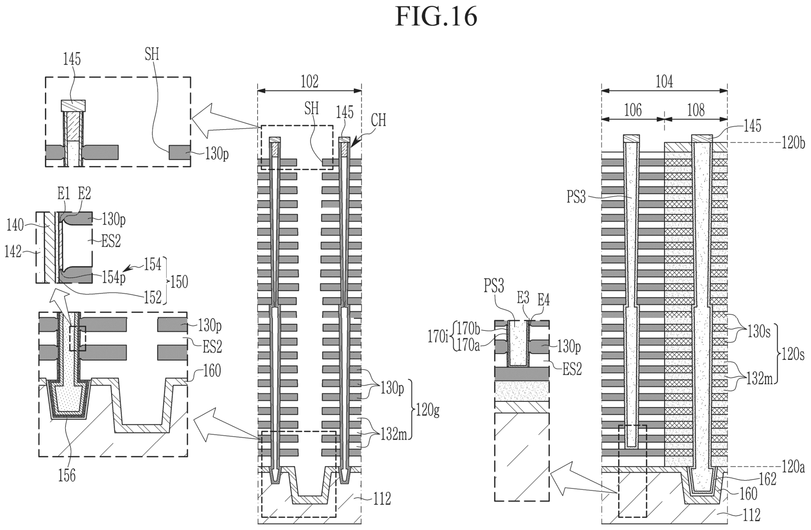

Subsequently, as illustrated in FIG. 16, the penetration part SH for the separation structure may be formed by removing the fourth penetration sacrificial layer PS4 (refer to FIG. 15) in the penetration part SH for the separation structure, and the second interlayer sacrificial layer 132m may be selectively removed through the penetration part SH for the separation structure. For example, in the process of removing the second interlayer sacrificial layer 132m, the second protective layer 145 may limit and/or prevent damage of the gate dielectric layer 150 included in the channel structure CH and/or the preliminary side insulation layer 170i.

In an embodiment, in the cell array region 102 and the first region 106, the second interlayer sacrificial layer 132m may be selectively removed. In the second region 108, the second interlayer sacrificial layer 132m may remain without being removed. Thereby, in the cell array region 102 and the first region 106, a third stacking structure 120g that includes the plurality of third interlayer sacrificial layers 130p while interposing a second space ES2 therebetween may be disposed. The second space ES2 may be formed of an empty space. In the second region 108, the sacrificial stacking structure 120s including the first interlayer sacrificial layer 130s and the second interlayer sacrificial layer 132m may remain.

For example, an etching process may be performed in a horizontal direction through the penetration part SH for the separation structure. Thereby, the second interlayer sacrificial layer 132m may be selectively removed in the cell array region 102 and the first region 106. For example, the second protective layer 145 may protect the channel structure CH and the preliminary side insulation layer 170i at or on the second surface 120b of the stacking structure. The process of removing the second interlayer sacrificial layer 132m may be performed by any of various processes (e.g., a wet etching process or the like).

For example, the first convex portions E2 may be disposed at opposite side surfaces of the second space ES2 in a thickness direction of a semiconductor device in an adjacent portion of the second space ES2 adjacent to the second layer 154. For example, the second convex portions E4 corresponding to the first convex portions E2 may be disposed at opposite side surfaces of the second space ES2 in the thickness direction of the semiconductor device in an adjacent portion of the second space ES2 adjacent to the second insulation layer 170b.

In the process of removing the second interlayer sacrificial layer 132m, the third layer 156 (refer to FIG. 13) included in the gate dielectric layer 150 of the channel structure CH and/or the third insulation layer 170c (refer to FIG. 13) included in the preliminary side insulation layer 170i that includes or is formed of a material same as a material of the second interlayer sacrificial layer 132m may be removed together. In the process of removing the second interlayer sacrificial layer 132m, a portion of the buffer layer 162 in the penetration part SH for the separation structure may be removed together. However, the embodiments are not limited thereto, and the third layer 156, the third insulation layer 170c, and/or at least a portion of the buffer layer 162 in the penetration part SH for the separation structure may remain.

Subsequently, as illustrated in FIG. 17, a cover insulation layer 132c, a blocking layer 132j, and a gate electrode 130 may be sequentially formed in the second space ES2 (refer to FIG. 16). Thereby, a fourth stacking structure 120h including the third interlayer sacrificial layer 130p and a gate structure (e.g., the cover insulation layer 132c, the blocking layer 132j, and the gate electrode 130) alternately disposed may be disposed in the cell array region 102 and the first region 106. In the second region 108, the sacrificial stacking structure 120s including the first interlayer sacrificial layer 130s and the second interlayer sacrificial layer 132m may remain.

For example, the cover insulation layer 132c may fill the first convex portions E2 of the second space ES2 in a portion adjacent to the channel structure CH, and may include the first convex portions E2 at opposite side surfaces in an adjacent portion the cover insulation layer 132c adjacent to the second layer 154. For example, the cover insulation layer 132c may fill the second convex portions E4 of the second space ES2 in a portion adjacent to the input/output connection wiring 174, and may include the second convex portions E4 at opposite side surfaces in an adjacent portion the cover insulation layer 132c adjacent to the second insulation layer 170b.

The process of forming of the cover insulation layer 132c, the blocking layer 132j, or the gate electrode 130 may be performed by any of various processes (e.g., a deposition process or the like). In an embodiment, between the process of forming the cover insulation layer 132c and the process of forming the blocking layer 132j and/or between the process of forming the cover insulation layer 132c and the process of the gate electrode 130, a heat treatment process of removing defects of the cover insulation layer 132c or improving a property of the cover insulation layer 132c may be performed.

The cover insulation layer 132c, the blocking layer 132j, or the gate electrode 130 in the penetration part SH for the separation structure may be removed, and the cover insulation layer 132c, the blocking layer 132j, or the gate electrode 130 may be disposed between the plurality of third interlayer sacrificial layers 130p.

In an embodiment, the cover insulation layer 132c may be formed and thereafter the gate electrode 130 may be formed. Therefore, the gate electrode 130 may not have a dangling structure in which the gate electrode 130 is hanging alone from the channel structure CH (e.g., the gate dielectric layer 150). Accordingly, defects, peeling, or the like at an interface between the gate electrode 130 and the gate dielectric layer 150 may be limited and/or prevented. The cover insulation layer 132c may be formed and thereafter the gate electrode 130 may be formed. Therefore, a problem induced when the gate electrode 130 is formed and thereafter an insulation layer including an oxide or the cover insulation layer 132c is formed may be limited and/or prevented. The cover insulation layer 132c may be formed before the process of forming the blocking layer 132j and/or the gate electrode 130, and thus, the heat treatment process of the cover insulation layer 132c may be performed. Thereby, property of the cover insulation layer 132c may be improved.

On the other than, in a comparative example using one replacement process, a nitride layer corresponding to a first interlayer sacrificial layer may be replaced with a gate electrode, and an oxide layer corresponding to a second interlayer sacrificial layer may be replaced with an air gap layer. After the gate electrode is formed, an oxide layer corresponding to a cover insulation layer may be formed in a position corresponding to a portion of the second interlayer sacrificial layer. Thereby, during a manufacturing process, the gate electrode may have a dangling structure in which the gate electrode is hanging alone from a gate dielectric layer. Thereby, an interface between the gate electrode and the gate dielectric layer may be unstable, and in severe cases, the gate electrode may be peeled from the gate dielectric layer. The oxide layer corresponding to the cover insulation layer is formed after the gate electrode is formed, and thus, a problem such as undesirable oxidation of a portion of the gate electrode may be induced in the process of forming the cover insulation layer.

Subsequently, as illustrated in FIG. 18, in the cell array region 102 and the first region 106, the third interlayer sacrificial layer 130p (refer to FIG. 17) may be selectively removed. Thereby, in the cell array region 102 and the first region 106, a gate stacking structure 120 including a plurality of gate electrodes 130 while interposing an air gap layer 130g therebetween may be disposed. In the second region 108, the sacrificial stacking structure 120s including the first interlayer sacrificial layer 130s and the second interlayer sacrificial layer 132m alternately stacked may be disposed.

For example, an etching process may be performed in a horizontal direction through the penetration part SH for the separation structure, and the third interlayer sacrificial layer 130p may be selectively removed in the cell array region 102 and the first region 106. For example, in the process of removing the third interlayer sacrificial layer 130p, the first protective layer 160 may protect the semiconductor substrate 112, and the second protective layer 145 may limit and/or prevent damage of the channel pad 144 and/or the channel layer 140 included in the channel structure CH and/or the third penetration sacrificial layer PS3. The process of removing the third interlayer sacrificial layer 130p may be performed by any of various processes (e.g., a wet etching process or the like).

Subsequently, as illustrated in FIG. 19, a separation structure 146 may be formed by filling the penetration part SH for the separation structure with a filling material. The process of forming the separation structure 146 may be performed by any of various processes (e.g., a deposition process or the like). Although a portion of the air gap layer 130g adjacent to the separation structure 146 may be filled in the process of forming the separation structure 146, another portion of the air gap layer 130g may remain. Thereby, the air gap layer 130g may be disposed between the plurality of gate electrodes 130.

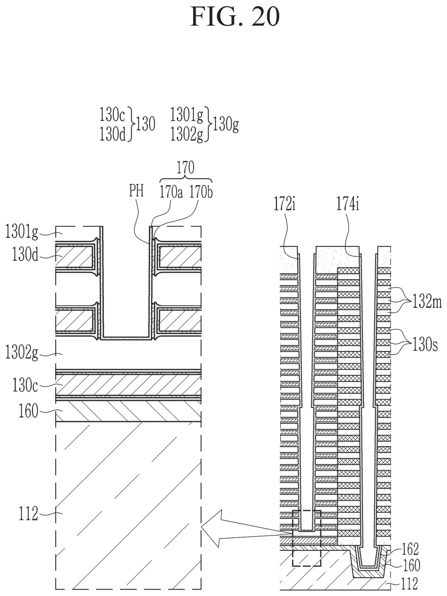

Subsequently, as illustrated in FIG. 20 to FIG. 24, a gate contact 172 and an input/output connection wiring 174 may be formed. FIG. 21 to FIG. 24 mainly illustrate a manufacturing process of the gate contact 172.

For example, as illustrated in FIG. 20, a penetration hole PH may be formed by removing the second protective layer 145 (refer to FIG. 19) and the third penetration sacrificial layer PS3 (refer to FIG. 19) in a portion corresponding to the gate contact 172 and the input/output connection wiring 174.

For example, an end of the penetration hole PH may be disposed at an upper portion of an adjacent air gap layer 1302g in a portion corresponding to the gate contact 172. The process of removing the second protective layer 145 and the third penetration sacrificial layer PS3 may be performed by any of various processes (e.g., an etching process or the like).

Subsequently, as illustrated in FIG. 21, a portion of the preliminary side insulation layer 170i at a lower surface of the penetration hole PH corresponding to the gate contact 172 may be removed. Thereby, the penetration hole PH may have a state that is connected to or communicates with the connection gate electrode 130c. For example, a portion of the preliminary side insulation layer 170i at a lower surface of the penetration hole PH corresponding to the input/output connection wiring 174 may be removed together.

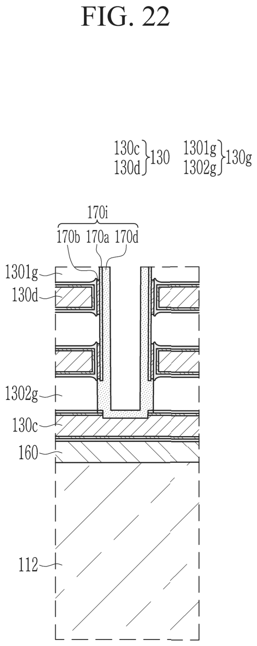

Subsequently, as illustrated in FIG. 22, an inner insulation layer 170d may be formed in the penetration hole PH corresponding to the gate contact 172. For example, the inner insulation layer 170d may be formed together in the penetration hole PH corresponding to the input/output connection wiring 174. The process of forming the inner insulation layer 170d may be performed by any of various processes (e.g., a deposition process or the like).

For example, the preliminary side insulation layer 170i in the penetration hole PH corresponding to the gate contact 172 may include the first insulation layer 170a, the second insulation layer 170b, and the inner insulation layer 170d. For example, the preliminary side insulation layer 170i in the penetration hole PH corresponding to the input/output connection wiring 174 may include the first insulation layer 170a, the second insulation layer 170b, the third insulation layer 170c (refer to FIG. 15), and the inner insulation layer 170d.

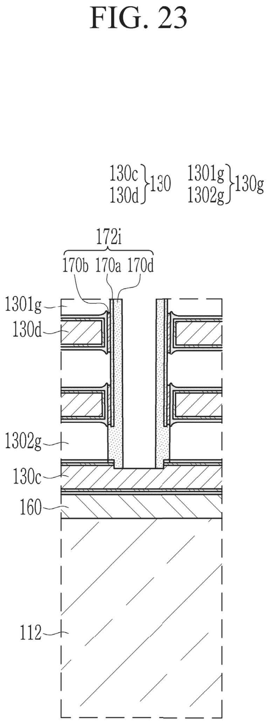

Subsequently, as illustrated in FIG. 23, a first side insulation layer 172i may be formed by removing a portion of the preliminary side insulation layer 170i (refer to FIG. 22) (e.g., the inner insulation layer 170d) at a lower surface of the penetration hole PH corresponding to the gate contact 172. For example, a portion of the inner insulation layer 170d at a lower surface of the penetration hole PH corresponding to the input/output connection wiring 174 may be removed together, and a second side insulation layer 174i (refer to FIG. 3) may be formed. The process of removing the portion of the inner insulation layer 170d may be performed by any of various processes (e.g., an etching process or the like).

Subsequently, as illustrated in FIG. 24, a first conductive portion 172c may be formed by filling the penetration hole PH with a conductive material. Thereby, a gate contact 172 may be formed. For example, the penetration hole PH corresponding to the input/output connection wiring 174 may be filled with a conductive material together, and a second conductive portion 174c (refer to FIG. 3) may be formed. The process of filling the conductive material may be performed by any of various processes (e.g., a deposition process or the like).

In an embodiment, it is described as an example that the first etched portion for forming the connection portion 172a of the gate contact 172 is formed to reach the first interlayer sacrificial layer 130s, and thereafter, the portion of the preliminary side insulation layer 170i at the lower portion of the penetration hole PH is removed. Thereby, the air gap layer 130g corresponding to the first interlayer sacrificial layer 130s may stably maintain. However, the embodiments are not limited thereto.

Subsequently, as illustrated in FIG. 25, a second cell wiring portion 190 may be formed. The second cell wiring portion 190 may include a second wiring layer 192 including a bit line BL, a second contact 194, a wiring insulation layer 196, and a bonding structure 198. Thereby, a preliminary cell region 100a may be formed.

Subsequently, as illustrated in FIG. 26, the preliminary cell region 100a may be bonded to a circuit region 200. For example, by a bonding process performing an annealing process in a state that the circuit region 200 and the preliminary cell region 100a are in contact with each other, the circuit region 200 and the preliminary cell region 100a may be bonded by hybrid bonding.

In FIG. 26, it is illustrated as an example that the preliminary cell region 100a having a reversed structure may be bonded to the circuit region 200. However, the embodiments are not limited thereto, and the circuit region 200 having a reversed structure may be bonded to the preliminary cell region 100a.

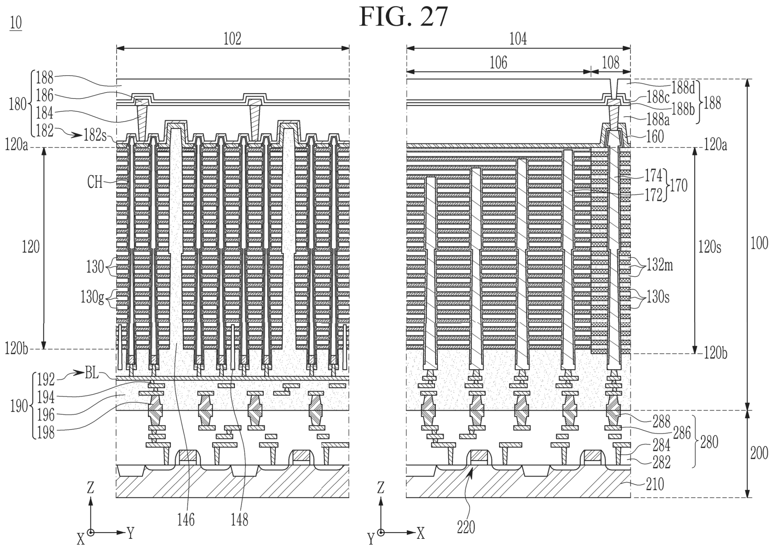

Subsequently, as illustrated in FIG. 27, the semiconductor substrate 112 (refer to FIG. 26) may be removed, a portion of the gate dielectric layer 150 (refer to FIG. 19) in a channel exposed portion CHP (refer to FIG. 4) of the channel structure portion CH may be removed, and a first cell wiring portion 180 may be formed.

For example, the process of removing the semiconductor substrate 112 may be performed by any of various processes (an etching process, a grinding process, a chemical mechanical polishing process, or the like). When the semiconductor substrate 112 is removed, a first surface 120a of the gate stacking structure 120 and a portion of the channel structure CH on the first surface 120a of the gate stacking structure 120 may be exposed.

Subsequently, a portion of the gate dielectric layer 150 in the channel exposed portion CHP of the channel structure CH may be removed, and the channel layer 140 (refer to FIG. 19) of the channel structure CH may be exposed to an outside. The process of removing the portion of the gate dielectric layer 150 may be performed by any of various processes (e.g., an etching process or the like).

Subsequently, the first cell wiring portion 180 may be formed. For example, the first cell wiring portion 180 may be formed by forming a first wiring layer 182 including a horizontal conductive layer 182s on the first surface 120a of the stacking structure, forming a first wiring insulation layer 188a on the first wiring layer 182, forming a first contact 184 and a pad 186, and forming a second wiring insulation layer 188b, a third wiring insulation layer 188c, and a fourth wiring insulation layer 188.

According to an embodiment, the first interlayer sacrificial layer 130s and the second interlayer sacrificial layer 132m may be formed and the first interlayer sacrificial layer 130s may be removed, and thereafter, the separation process may be performed using a space in which the first interlayer sacrificial layer 130s is removed/ Therefore, the plurality of storage portions 154p may be easily formed. The third interlayer sacrificial layer 130p may be formed in the space in which the first interlayer sacrificial layer 130s is removed and the second interlayer sacrificial layer 132m may be removed, and thereafter, the cover insulation layer 132c, the gate electrode 130, and/or the blocking layer 132j may be formed in the space in which the second interlayer sacrificial layer 132m is removed. Therefore, the cover insulation layer 132c may have a structure surrounding and protecting the gate electrode 130 and/or the blocking layer 132j. Thereby, the gate electrode 130 and/or the blocking layer 132j may not have a dangling structure in which the gate electrode 130 and/or the blocking layer 132j is hanging alone from the gate dielectric layer 150, and stability of the gate electrode 130 and/or the blocking layer 132j may be improved. By removing the third interlayer sacrificial layer 130p, the air gap layer 130g may be easily formed. Accordingly, a semiconductor device having improved performance and reliability may be easily and stably formed. For example, the stacking structure may include the sacrificial stacking structure 120s and the gate stacking structure 120, and a form of the stacking structure may maximally maintain and performance and reliability of the semiconductor device may be improved.

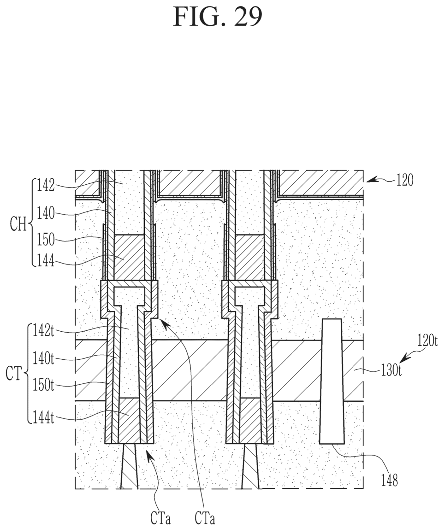

Hereinafter, referring to FIG. 28 and FIG. 29, semiconductor devices according to embodiments and manufacturing methods thereof will be described in detail.

FIG. 28 is a partial cross-sectional view illustrating a semiconductor device according to an embodiment. FIG. 28 illustrates a portion corresponding to a central enlarged circle in FIG. 4.

Referring to FIG. 28, in a semiconductor device according to an embodiment, a cover insulation layer 132c adjacent to an air gap layer 130g may include a first cover portion (e.g., a horizontal portion), a second cover portion (e.g., a first vertical portion), and a third cover portion (e.g., a second vertical portion). The first cover portion may extend in a horizontal direction on each of a first surface (an upper surface in FIG. 28) and a second surface (a lower surface in FIG. 28) of a plurality of gate electrodes 130. The second cover portion may be disposed between the gate electrode 130 and a second layer 154 (e.g., a storage portion 154p) and may extend in a vertical direction. The third cover portion may be disposed on a first layer 152 between the plurality of gate electrodes 130 and extend in the vertical direction.

For example, the cover insulation layer 132c may include a first cover insulation layer 132a and a second cover insulation layer 132b. The first cover insulation layer 132a may include a first insulation portion 1321a and a second insulation portion 1322a. The first insulation portion 1321a may constitute a portion of the first cover portion, and the second insulation portion 1322a may constitute the second cover portion. The second cover insulation layer 132b may include a third insulation portion 1321b and a fourth insulation portion 1322b. The third insulation portion 1321b may constitute a portion of the first cover portion, and the fourth insulation portion 1322b may constitute the third cover portion.

For example, in a thickness direction of the semiconductor device (a Z-axis direction in the drawings), at least a portion of the first cover portion of the cover insulation layer 132c (e.g., the first insulation portion 1321a of the first cover insulation layer 132a), together with the gate electrode 130, may be disposed at a position corresponding to a second interlayer sacrificial layer 132m (refer to FIG. 1). For example, a first surface (an upper surface in FIG. 28) of the first insulation portion 1321a on a first surface (an upper surface in FIG. 28) of the gate electrode 130 and a first surface of the second interlayer sacrificial layer 132m corresponding thereto may be disposed on a same plane. For example, a second surface (a lower surface in FIG. 28) of the first insulation portion 1321a on a second surface (a lower surface in FIG. 28) of the gate electrode 130 and a second surface of the second interlayer sacrificial layer 132m corresponding thereto may be disposed on a same plane. In the thickness direction of the semiconductor device, another portion of the first cover portion of the cover insulation layer 132c (e.g., the third insulation portion 1321b of the second cover insulation layer 132b), together with the air gap layer 130g, may be disposed to correspond to or overlap a first interlayer sacrificial layer 130s (refer to FIG. 1).

In an embodiment, after a third interlayer sacrificial layer is removed to form the air gap layer 130g in a cell array region and a first region, the second cover insulation layer 132b may be further formed on the channel structure CH and the first cover insulation layer 132a exposed through the air gap layer 130g. For example, the third insulation portion 1321b of the second cover insulation layer 132b may extend in a horizontal direction on the first insulation portion 1321a of the first cover insulation layer 132a that is disposed on each of the first surface and the second surface of the gate electrode 130. For example, the fourth insulation portion 1322b of the second cover insulation layer 132b may extend in the vertical direction on a side surface of the channel structure CH (e.g., on a side surface of the first layer 152) in a portion in which the air gap layer 130g is disposed.

For example, the second cover insulation layer 132b may include a material different from a material of a blocking layer 132j, and may include or be formed of a material same as a material of the first cover insulation layer 132a. When the first cover insulation layer 132a and the second cover insulation layer 132b may include or be formed of a same material, a boundary between the first cover insulation layer 132a and the second cover insulation layer 132b (e.g., a boundary between the first insulation portion 1321a and the third insulation portion 1321b) may not be seen or confirmed. However, the embodiments are not limited thereto. For example, the first cover insulation layer 132a and the second cover insulation layer 132b may include different materials. In some embodiments, even when the first cover insulation layer 132a and the second cover insulation layer 132b may include or be formed of a same material, the boundary between the first cover insulation layer 132a and the second cover insulation layer 132b (e.g., the boundary between the first insulation portion 1321a and the third insulation portion 1321b) may be seen or confirmed through a difference in process condition, a difference in whether a heat treatment is performed or not, a passage of time, or the like.

In an embodiment, when the second cover insulation layer 132b is included, third convex portions E5 may be included at opposite side surfaces of the cover insulation layer 132c in a portion adjacent to the second layer 154. The second cover insulation layer 132b may be thin such that the third convex portions E5 maintain, and thus, a volume of the air gap layer 130g may be sufficient.

In an embodiment, the cover insulation layer 132c may include the third cover portion that covers a portion of the first layer 152 exposed through the plurality of gate electrodes 130. Accordingly, reliability of the semiconductor device may be improved.

FIG. 29 is a partial cross-sectional view illustrating a semiconductor device according to an embodiment. FIG. 29 illustrates portions of a gate stacking structure 120 and a channel structure CH, a selection stacking structure 120t, a selection channel structure CT, and a separation pattern 148. For simple illustration and a clear understanding, FIG. 29 schematically illustrates a selection gate dielectric layer 150t, a selection channel layer 140t, a selection core insulation layer 142t, and a selection channel pad 144t of the selection channel structure CT.

Referring to FIG. 29, in an embodiment, a selection stacking structure 120t may be disposed on a gate stacking structure 120. In FIG. 29, it is illustrated as an example that the selection stacking structure 120t includes one selection gate electrode 130t. In some embodiment, the selection stacking structure 120t may include a plurality of selection gate electrodes 130t while interposing an interlayer insulation layer therebetween. A separation pattern 148 may pass through the selection stacking structure 120t.

For example, the selection gate electrode 130t may include a string selection gate electrode for selecting a string, and the separation pattern 148 may be a string separation pattern for separating the string. In some embodiments, the selection gate electrode 130t may further include a gate electrode other than the string selection gate electrode for selecting the string.

The selection gate electrode 130t may include any of various conductive materials. For example, the selection gate electrode 130t may include or be formed of a metallic material, a semiconductor material, metal nitride, or a combination thereof. For example, the selection gate electrode 130t may include or be formed of a doped semiconductor material (e.g., a doped polycrystalline silicon).

In an embodiment, a selection channel structure CT extending to pass through the selection stacking structure 120t and electrically connected to a channel structure CH may be disposed. The selection channel structure CT may include a selection channel layer 140t, a selection gate dielectric layer 150t, and a selection channel pad 144t, and further include a selection core insulation layer 142t, like the channel structure CH.

In an embodiment, the selection channel structure CT may include a selection expanded portion CTb in a portion adjacent to the channel structure CH. The selection expanded portion CTb may extend in a horizontal direction than another portion. For example, the selection channel structure CT may include a selection penetration portion CTa passing through the selection stacking structure 120t, and a selection expanded portion CTb having an area greater than an area of the selection penetration portion CTa. The selection expanded portion CTb may be disposed in a portion in which a second protective layer 145 (refer to FIG. 2) is removed. The second protective layer 145 was disposed on a channel pad 144 of the channel structure CH. The second protective layer 145 that was disposed on the channel pad 144 may be a kind of self-alignment pad, and the channel structure CH and the selection channel structure CT may be connected with a large area by the selection expanded portion CTb. Thereby, a connection property between the channel structure CH and the selection channel structure CT may be improved.

An example of an electronic system including a semiconductor device will be described in detail below.

FIG. 30 schematically illustrates an electronic system including a semiconductor device according to an embodiment.

Referring to FIG. 30, an electronic system 1000 according to an embodiment may include a semiconductor device 1100 and a controller 1200 that is electrically connected to the semiconductor device 1100. The electronic system 1000 may be a storage device that includes one or a plurality of semiconductor devices 1100 or an electronic device that includes the storage device. For example, the electronic system 1000 may be a solid-state drive (SSD) device, a universal serial bus (USB), a computing system, a medical device, or a communication device that includes one or a plurality of semiconductor devices 1100.

The semiconductor device 1100 may be a non-volatile memory device/ For example, the semiconductor device 1100 may be a NAND flash memory device described with reference to FIG. 1 to FIG. 29. The semiconductor device 1100 may include a first structure 1100F and a second structure 1100S that is disposed on the first structure 1100F. The first structure 1100F may be a peripheral circuit structure that includes a decoder circuit 1110, a page buffer 1120, and a logic circuit 1130. The second structure 1100S may be a memory cell structure that includes a bit line BL, a common source line CSL, a word line WL, first and second gate upper lines UL1 and UL2, first and second gate lower lines LL1 and LL2, and a memory cell string CSTR between the bit line BL and the common source line CSL.

In the second structure 1100S, each of memory cell strings CSTR may include lower transistors LT1 and LT2 that are adjacent to the common source line CSL, upper transistors UT1 and UT2 that are adjacent to the bit line BL, and a plurality of memory cell transistors MCT between the lower transistors LT1 and LT2 and the upper transistors UT1 and UT2. A number of the lower transistors LT1 and LT2 and a number of the upper transistors UT1 and UT2 may be variously modified according to an embodiment.

In an embodiment, the lower transistor LT1 or LT2 may include a ground selection transistor, and the upper transistor UT1 or UT2 may include a string selection transistor. The first and second gate lower lines LL1 and LL2 may be gate electrodes of the lower transistors LT1 and LT2, respectively. The word line WL may be a gate electrode of the memory cell transistor MCT, and the gate upper lines UL1 and UL2 may be gate electrodes of the upper transistors UT1 and UT2, respectively.

The common source line CSL, the first and second gate lower lines LL1 and LL2, the word line WL, and the first and second gate upper lines UL1 and UL2 may be electrically connected to the decoder circuit 1110 through a first connection wiring 1115 that extends to the second structure 1100S within the first structure 1100F. The bit line BL may be electrically connected to the page buffer 1120 through a second connection wiring 1125 that extends to the second structure 1100S within the first structure 1100F.

In the first structure 1100F, the decoder circuit 1110 and the page buffer 1120 may execute a control operation for at least one memory cell transistor selected from the plurality of memory cell transistors MCT. The decoder circuit 1110 and the page buffer 1120 may be controlled by the logic circuit 1130. The semiconductor device 1100 may communicate with the controller 1200 through an input/output pad 1101 that is electrically connected to the logic circuit 1130. The input/output pad 1101 may be electrically connected to the logic circuit 1130 through an input/output connection wiring 1135 that extends to the second structure 1100S within the first structure 1100F.

The controller 1200 may include a processor 1210, a NAND controller 1220, and a host interface 1230. In some embodiments, the electronic system 1000 may include a plurality of semiconductor devices 1100, and in this case, the controller 1200 may control the plurality of semiconductor devices 1100.

The processor 1210 may control an overall operation of the electronic system 1000 including the controller 1200. The processor 1210 may operate according to predetermined firmware, and may access the semiconductor device 1100 by controlling the NAND controller 1220. The NAND controller 1220 may include a NAND interface 1221 that processes communication with the semiconductor device 1100. A control command for controlling the semiconductor device 1100, data to be written in the memory cell transistor MCT of the semiconductor device 1100, and data to be read from the memory cell transistor MCT of the semiconductor device 1100, or the like may be transmitted through the NAND interface 1221. The host interface 1230 may provide a communication function between the electronic system 1000 and an external host. When a control command is received from the external host through the host interface 1230, the processor 1210 may control the semiconductor device 1100 in response to the control command.

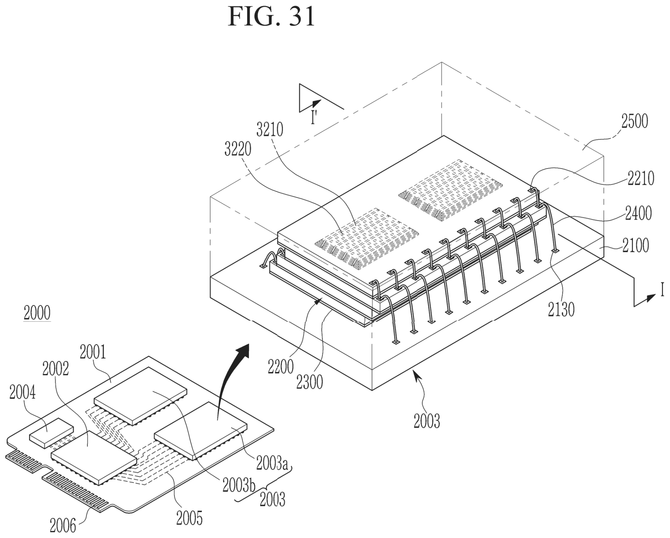

FIG. 31 is a perspective view schematically illustrating an electronic system including a semiconductor device according to an embodiment.

Referring to FIG. 31, an electronic system 2000 according to an embodiment may include a main substrate 2001, a controller 2002 that is mounted on the main substrate 2001, one or more semiconductor packages 2003, and a DRAM 2004. The semiconductor package 2003 and the DRAM 2004 may be connected to the controller 2002 through a wiring pattern 2005 that is provided on the main substrate 2001.

The main substrate 2001 may include a connector 2006 that includes a plurality of pins coupled to the external host. A number and an arrangement of the plurality of pins in the connector 2006 may vary depending on a communication interface between the electronic system 2000 and the external host. In an embodiment, the electronic system 2000 may communicate with the external host according to any one of interfaces such as a universal serial bus (USB), a peripheral component interconnect express (PCI-Express), a serial advanced technology attachment (SATA), or an M-Phy for a universal flash storage (UFS). In an embodiment, the electronic system 2000 may operate by power that is supplied from the external host through the connector 2006. The electronic system 2000 may further include a power management integrated circuit (PMIC) that distributes the power supplied from the external host to the controller 2002 and the semiconductor package 2003.

The controller 2002 may write data in the semiconductor package 2003 or may read data from the semiconductor package 2003, and may improve an operating speed of the electronic system 2000.

The DRAM 2004 may be a buffer memory for mitigating or buffering a speed difference between the semiconductor package 2003, which is a data storage space, and the external host. The DRAM 2004 that is included in the electronic system 2000 may also be a kind of cache memory, and may also provide a space for temporarily storing data in a control operation for the semiconductor package 2003. When the electronic system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b that are spaced apart from each other. Each of the first and second semiconductor packages 2003a and 2003b may be a semiconductor package that includes a plurality of semiconductor chips 2200. Each of the first and second semiconductor packages 2003a and 2003b may include a package substrate 2100, a semiconductor chip 2200 that is disposed on the package substrate 2100, an adhesive layer 2300 at a lower surface of each semiconductor chip 2200, a connection structure 2400 that electrically connects the semiconductor chip 2200 and the package substrate 2100, and a molding layer 2500 that covers the semiconductor chip 2200 and the connection structure 2400 on the package substrate 2100.

The package substrate 2100 may be a printed circuit board that includes a package upper pad 2130. Each semiconductor chip 2200 may include an input/output pad 2210. The input/output pad 2210 may correspond to an input/output pad 1101 of FIG. 30. Each semiconductor chip 2200 may include a gate stacking structure 3210 and a channel structure 3220. The semiconductor chip 2200 may include a semiconductor device described with reference to FIG. 1 to FIG. 29.

In an embodiment, the connection structure 2400 may be a bonding wire that electrically connects the input/output pad 2210 and the package upper pad 2130. Accordingly, in each of the first and second semiconductor packages 2003a and 2003b, the semiconductor chips 2200 may be electrically connected to each other using a bonding wire type, and the semiconductor chip 2200 may be electrically connected to the package upper pad 2130 of the package substrate 2100 using a bonding wire type. In some embodiments, in each of the first and second semiconductor packages 2003a and 2003b, the semiconductor chips 2200 may be electrically connected to each other by a connection structure that includes a through silicon via (TSV) instead of the connection structure 2400 of the bonding wire type.

In an embodiment, the controller 2002 and the semiconductor chip 2200 may be included in one package. For example, the controller 2002 and the semiconductor chip 2200 may be mounted on a separate interposer substrate that is different from the main substrate 2001, and the controller 2002 and the semiconductor chip 2200 may be connected to each other by a wiring of the interposer substrate.

FIG. 32 is a cross-sectional view schematically illustrating a semiconductor package according to an embodiments. FIG. 32 illustrates an embodiment of the semiconductor package 2003 in FIG. 31, and conceptually illustrates a region obtained by cutting the semiconductor package 2003 in FIG. 31 along a line I-I'.

Referring to FIG. 32, in a semiconductor package 2003, the package substrate 2100 may be a printed circuit board. The package substrate 2100 may include a package substrate body portion 2120, a package upper pad 2130 at an upper surface of the package substrate body portion 2120, a package lower pad 2125 disposed at a lower surface of the package substrate body portion 2120 or exposed through the lower surface of the package substrate body portion 2120, and an internal wiring 2135 electrically connecting the package upper pad 2130 and the package lower pad 2125 inside the package substrate body portion 2120. The package upper pad 2130 may be electrically connected to the connection structure 2400. The package lower pad 2125 may be connected to a wiring pattern 2005 of the main substrate 2001 of the electronic system 2000 illustrated in FIG. 31 through a conductive connection portion 2800.

In a semiconductor package 2003, each semiconductor chip 2200 may include a semiconductor substrate 4010, a first structure 4100 on the semiconductor substrate 4010, and a second structure 4200 disposed on the first structure 4100 and bonded to the first structure 4100 by a wafer bonding type.

The first structure 4100 may include a peripheral circuit region including a peripheral wiring 4110 and a first bonding structure 4150. The second structure 4200 may include a common source line 4205, a gate stacking structure 4210 between the common source line 4205 and the first structure 4100, a channel structure 4220 and a separation structure 4230 penetrating the gate stacking structure 4210, and a second bonding structure 4250 electrically connected to the channel structure 4220 and a word line WL (refer to FIG. 30) of the gate stacking structure 4210. For example, the second bonding structure 4250 may be electrically connected to the channel structure 4220 and the word line WL through a bit line 4240 electrically connected to the channel structure 4220 and a gate connection wiring electrically connected to the word line WL. The first bonding structure 4150 of the first structure 4100 and the second bonding structure 4250 of the second structure 4200 may be in contact with and bonded to each other. For example, portions of the first bonding structure 4150 and the second bonding structure 4250 where the first bonding structure 4150 and the second bonding structure 4250 are bonded may include copper (Cu).

In a semiconductor chip 2200 or a semiconductor device according to an embodiment, a charge storage layer may have a separated storage structure, a gate stacking structure may include an air gap layer, and a cover insulation layer may surround and protect a gate electrode and a blocking layer, and therefore, performance and reliability may be improved.

Each of the semiconductor chips 2200 may further include an input/output pad 2210 and an input/output connection wiring 4265 at a lower portion of the input/output pad 2210. The input/output connection wiring 4265 may be electrically connected to a part of the second bonding structures 4250.

In an embodiment, in the semiconductor package 2003, a plurality of semiconductor chips 2200 may be electrically connected to each other by the connection structure 2400 having a bonding wire type. In some embodiments, the plurality of semiconductor chips 2200 or a plurality of portions constituting the plurality of semiconductor chips 2200 may be electrically connected by a connection structure including a through silicon via (TSV).

According to an example embodiment, a method of manufacturing a semiconductor device according to an embodiment may include forming a sacrificial stacking structure, forming a channel structure, removing a plurality of first interlayer sacrificial layers, a separation process, forming a plurality of third interlayer sacrificial layers, removing a plurality of second interlayer sacrificial layers, forming a cover insulation layer, forming a plurality of gate electrodes, and removing the plurality of third interlayer sacrificial layers. In the forming of the sacrificial stacking structure, the plurality of first interlayer sacrificial layers and the plurality of second interlayer sacrificial layers may be alternately stacked to each other to form the sacrificial stacking structure on a substrate. In the forming of the channel structure, the channel structure may pass through the sacrificial stacking structure, and may include a channel layer and a gate dielectric layer. The gate dielectric layer may include a charge storage layer. In the separation process, a portion of the charge storage layer between the plurality of second interlayer sacrificial layers is removed such that the charge storage layer may have a separated storage structure including a plurality of storage portions spaced apart from each other. In the forming of the plurality of third interlayer sacrificial layers, the plurality of third interlayer sacrificial layers may be formed between the plurality of second interlayer sacrificial layers. In the forming of the cover insulation layer, the cover insulation layer is formed on the plurality of third interlayer sacrificial layers. In the forming of the plurality of gate electrodes, the plurality of gate electrodes are formed on the cover insulation layer between the plurality of third interlayer sacrificial layers. In the removing of the plurality of third interlayer sacrificial layers, the plurality of third interlayer sacrificial layers may be removed to form a plurality of air gap layers.

A material of the cover insulation layer may be the same as a material of the second interlayer sacrificial layer.

The first interlayer sacrificial layer may include nitride, and the second interlayer sacrificial layer may include oxide.

The semiconductor device may include a cell array region, and a connection region that includes a first region and a second region. At least one of the removing of the plurality of first interlayer sacrificial layers, the separation process, the forming of the plurality of third interlayer sacrificial layers, the removing of the plurality of second interlayer sacrificial layers, the forming of the cover insulation layer, the forming of the plurality of gate electrodes, and the removing of the plurality of third interlayer sacrificial layers may be performed in the cell array region and the first region. In the cell array region and the first region, the gate stacking structure including the plurality of gate electrodes and the plurality of air gap layers alternately stacked to each other may be disposed. In the second region, the sacrificial stacking structure may be disposed.

Before the removing of the plurality of first interlayer sacrificial layers, a plurality of penetration parts that individually pass through the sacrificial stacking structure and reach the plurality of first interlayer sacrificial layers, respectively, may be formed. After the removing of the plurality of third interlayer sacrificial layers, a gate electrode at a lower portion of a penetration part may be removed in the plurality of penetration parts, and an inner insulation layer and a conductive portion may be formed in the plurality of penetration parts to form a plurality of gate contacts. Thereby, the plurality of gate contacts may individually pass through the gate stacking structure including the plurality of air gap layers and the plurality of gate electrodes.

At least one of the plurality of storage portions may include outer portions at opposite sides and a flat portion between the outer portions, and a thickness of the at least one of the plurality of storage portions may vary in the outer portions. A length of the flat portion may be greater than a thickness of the gate electrode in the thickness direction of the stacking structure.

At least one of the plurality of storage portions may include outer portions at opposite sides and a flat portion between the outer portions. A thickness of the at least one of the plurality of storage portions may vary in the outer portions, and a surface of at least one of the outer portions may be concave and recessed toward an inner side in the thickness direction of the stacking structure.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While some examples have been described in connection with what is presently considered to be some practical embodiments, it is to be understood that the disclosure is not limited to the disclosed embodiments, and that the disclosure is intended to cover various modifications and equivalent arrangements included within the scope of the appended claims.

## Claims

1. A semiconductor device, comprising:
a stacking structure including a sacrificial stacking structure (120s) and a gate stacking structure (120, 3210, 4210); and
a channel structure (CH, 3220, 4220) passing through the gate stacking structure (120, 3210, 4210), wherein:
the channel structure (CH, 3220, 4220) includes a channel layer (140) and a gate dielectric layer (150),
the gate dielectric layer (150) includes a charge storage layer (154) including a plurality of storage portions (154p) spaced apart from each other,
the sacrificial stacking structure (120s) includes a first interlayer sacrificial layer (130s) and a second interlayer sacrificial layer (132m),
the first interlayer sacrificial layer (130s) and the second interlayer sacrificial layer (132m) include different materials and are alternately stacked on each other,
the gate stacking structure (120, 3210, 4210) includes an air gap layer (130g) and a gate structure,
in a thickness direction of the stacking structure, the air gap layer (130g) corresponds to at least a portion of the first interlayer sacrificial layer (130s) and the gate structure corresponds to at least the second interlayer sacrificial layer (132m),
the gate structure includes a gate electrode (130) and a cover insulation layer (132c),
the cover insulation layer (132c) is on the gate electrode (130) and is adjacent to the air gap layer (130g),
the cover insulation layer (130g) includes a first cover portion extending in a horizontal direction on the gate electrode (130), and
the gate electrode (132c) and at least a portion of the first cover portion of the cover insulation layer (132c) is disposed to correspond to or overlap the second interlayer sacrificial layer (132m) in the thickness direction of the stacking structure.

2. The semiconductor device of claim 1, wherein a material of the cover insulation layer (132c) is the same as a material of the second interlayer sacrificial layer (132m).

3. The semiconductor device of claim 1 or 2, wherein
the first interlayer sacrificial layer (130s) includes nitride, and
the second interlayer sacrificial layer (132m) includes oxide.

4. The semiconductor device of any one of claims 1 to 3, wherein
at least one of the plurality of storage portions (154p) includes outer portions at opposite sides and a flat portion (154f) between the outer portions (154e),
a thickness of the at least one of the plurality of storage portions (154p) varies in the outer portions, and
a length of the flat portion (154f) is greater than a thickness of the gate electrode (130) in the thickness direction of the stacking structure.

5. The semiconductor device of any one of claims 1 to 3, wherein
at least one of the plurality of storage portions (154p) includes outer portions (154e) at opposite sides and a flat portion (154f) between the outer portions (154e),
a thickness of the at least one of the plurality of storage portions (154p) varies in the outer portions (154e), and
a surface of at least one of the outer portions (154e) is concave and recessed toward an inner side in the thickness direction of the stacking structure.

6. The semiconductor device of any one of claims 1 to 5, wherein
the cover insulation layer (132c) further includes a second cover portion between the gate electrode (130) and the charge storage layer (154), and
a side surface of the second cover portion in a portion adjacent to the channel structure (CH, 3220, 4220) has a convex portion that is convexly protruding in the thickness direction of the stacking structure.

7. The semiconductor device of any one of claims 1 to 6, wherein
the gate structure further includes a blocking layer (132j),
the blocking layer (132j) is between the cover insulation layer (132c) and the gate electrode (130), and
a material in the blocking layer (132j) is different from a material of the cover insulation layer (132c).

8. The semiconductor device of any one of claims 1 to 7, further comprising a gate contact (172), wherein
the gate electrode (130) includes a plurality of gate electrodes (130),
the air gap layer (130g) includes a plurality of air gap layers (130g) between the plurality of gate electrodes (130),
the gate contact (172) individually passes through the gate stacking structure (120, 3210, 4210) that includes the plurality of air gap layers (130g) and the plurality of gate electrodes (130), and
the gate contact (172) is electrically connected to a connection gate electrode (130c) of the plurality of gate electrodes (130).

9. The semiconductor device of claim 8, wherein
the gate contact (172) includes a conductive portion (172c) and a side insulation layer (172i) on a side surface of the conductive portion (172c),
the side insulation layer (172i) includes a first side portion, a second side portion, and a third side portion,
a portion of the first side portion of the side insulation layer (172i) corresponds to a penetrated gate electrode of the plurality of gate electrodes (130),
the second side portion of the side insulation layer (172i) corresponds to a separated air gap layer (1301g) of the plurality of air gap layers (130g),
the separated air gap layer (1301g) is spaced apart from the connection gate electrode (130c), the third side portion of the side insulation layer (172i) corresponds to an adjacent air gap layer (1302g) of the plurality of air gap layers (130g),
the adjacent air gap layer (1302g) is adjacent to the connection gate electrode (130c), and
a stacking structure of the third side portion of the side insulation layer (172i) is different from at least one of a stacking structure of the first side portion of the side insulation layer (172i) and a stacking structure of the second side portion of the side insulation layer (172i).

10. The semiconductor device of any one of claims 1 to 9, further comprising:
a first protective layer (160) on a first surface of the stacking structure, wherein
the first surface of the stacking structure is opposite a second surface of the stacking structure,
the channel structure (CH, 3220, 4220) includes a channel expanded portion (CHb),
the channel expanded portion (CHb) protrudes from the first surface of the stacking structure, and
a material of the first protective layer (160) is different from a material of the second interlayer sacrificial layer (132m).

11. The semiconductor device of any one of claims 1 to 9, further comprising:
a penetration structure (174) passing through the stacking structure, wherein
a first surface of the stacking structure is opposite a second surface of the stacking structure,
the penetration structure (174) includes a penetration portion (174a) and an expanded portion (174b),
the penetration portion (174a) passes through the stacking structure,
the expanded portion (174b) is on the first surface of the stacking structure, and
a width or an area of the expanded portion (174b) is greater than a width or an area of the penetration portion (174a).

12. The semiconductor device of claim 11, further comprising a first protective layer (160) on the first surface of the stacking structure and the expanded portion,
wherein a material of the first protective layer (160) is different from a material of the second interlayer sacrificial layer (132m).

13. The semiconductor device of any one of claims 1 to 12, wherein
the channel structure (CH, 3220, 4220) includes a channel pad (144) and a second protective layer (145),
the channel pad (144) is on at least one of the channel layer (140) and the gate dielectric layer (150),
the second protective layer (145) is at least on the channel pad (144), and
a material of the second protective layer (145) is different from a material of the second interlayer sacrificial layer (132m).

14. The semiconductor device of any one of claims 1 to 13, further comprising:
a selection stacking structure (120t) on the gate stacking structure (120, 3210, 4210);
a selection channel structure (CT) electrically connected to the channel structure (CH, 3220, 4220); and
a separation pattern (148) passing through at least a portion of the selection stacking structure (120t), wherein
the selection channel structure (CT) includes a selection penetration portion (CTa) and a selection expanded portion (CTb),
the selection penetration portion (CTa) passes through the selection stacking structure (120t), and
an area of the selection expanded portion (CTb) is greater than an area of the selection penetration portion (CTa).

15. The semiconductor device of any one of claims 1 to 14, wherein the semiconductor device is a bonding semiconductor device in which a cell region (100) including the stacking structure and the channel structure (CH, 3220, 4220) is bonded to a circuit region (200).
